# EUROPEAN PATENT SPECIFICATION

(11) **EP 4 270 910 B1**
(45) Date of publication and mention of the grant of the patent: **24.12.2025**
(21) Application number: 23707247.5
(22) Date of filing: 17.02.2023
(51) Int. Cl.: H04M 1/02, H05K 5/06, G06F 1/16

(54) **BLOCKING MEMBER AND ELECTRONIC DEVICE COMPRISING SAME**
BLOCKIERELEMENT UND ELEKTRONISCHE VORRICHTUNG DAMIT
ÉLÉMENT DE BLOCAGE ET DISPOSITIF ÉLECTRONIQUE LE COMPRENANT

(30) Priority: 10.03.2022 KR 20220030160; 31.05.2022 KR 20220067193
(43) Date of publication of application: 01.11.2023
(73) Proprietor: Samsung Electronics Co., Ltd., Suwon-si, Gyeonggi-do 16677 (KR)
(72) Inventor: SHIN, Moonchul, Suwon-si, Gyeonggi-do 16677 (KR); KANG, Youngmin, Suwon-si, Gyeonggi-do 16677 (KR); YOON, Yeonggyu, Suwon-si, Gyeonggi-do 16677 (KR); CHO, Joongyeon, Suwon-si, Gyeonggi-do 16677 (KR); CHOI, Junyoung, Suwon-si, Gyeonggi-do 16677 (KR); YOON, Byounguk, Suwon-si, Gyeonggi-do 16677 (KR); LEE, Junghyeob, Suwon-si, Gyeonggi-do 16677 (KR); CHO, Sunggun, Suwon-si, Gyeonggi-do 16677 (KR)
(74) Representative: Gulde & Partner
(86) International application number: PCT/KR2023/002350
(87) International publication number: WO 2023/171932

(56) References cited:
- EP-A1- 4 152 121
- WO-A1-2021/230601
- KR-A- 20060 012 965
- KR-A- 20210 022 921
- KR-A- 20210 046 488
- KR-A- 20210 141 185
- US-A1- 2010 285 850

## Description

### [Technical Field]

Various embodiments of the disclosure relate to an electronic device, for example, a blocking member and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling or e-wallet function. Such electronic devices become compact enough for users to carry in a convenient way.

As mobile communication services extend up to multimedia service sectors, the display of the electronic device may be increased to allow the user's satisfactory use of multimedia services as well as voice call or text messaging services. WO 2021/230601 A1 relates to a technology for protecting a flexible display.

### [Disclosure]

### [Technical Problem]

An electronic device (e.g., a portable terminal) may include a display with a flat surface or both a flat and curved surface. An electronic device including a display may have a limitation in realizing a screen larger than the size of the electronic device due to the fixed display structure. Accordingly, research has been conducted on electronic devices including a rollable display.

An electronic device with a rollable display may have its partial area extended or shrunken when slid.

In an electronic device including a rollable display, an external foreign object may be introduced into the inside of the electronic device through a portion where the rollable display and the housing surrounding the rollable display face each other or through a gap formed between the portions facing each other.

According to various embodiments of the disclosure, there may be provided a blocking member that blocks a foreign object from entering through a gap formed between the display and the housing of an electronic device, and the electronic device including the same.

The disclosure is not limited to the foregoing embodiments but various modifications or changes may rather be made thereto without departing from the scope of the disclosure.

### [Technical Solution]

The invention is set out in the appended set of claims. According to various embodiments of the disclosure, an electronic device may comprise a housing including a first housing and a second housing for guiding a slide of the first housing; a display including a first display area disposed on the first housing and a second display area extending from the first display area and configured to move at least a portion of the second display area based on the slide of the first housing; a supporting structure configured to support at least a portion of the first display area or at least a portion of the second display area and including a plurality of bars; and a blocking member for blocking influx of an external foreign object through a gap between the housing and the display. When the first housing slides, at least one of the plurality of bars may be configured to pressurize and push out the blocking member to space the display and the blocking member apart from each other.

According to various embodiments of the disclosure, an electronic device may comprise a housing including a first housing and a second housing for guiding a slide of the first housing; a display including a first display area disposed on the first housing and a second display area extending from the first display area and configured to move at least a portion of the second display area based on the slide of the first housing; a supporting structure configured to support at least a portion of the first display area or at least a portion of the second display area and including a plurality of bars; and a blocking member disposed in the housing. The blocking member may include a base portion including at least a portion coupled to the housing; a blocking portion slidably coupled to the base portion; and an elastic portion disposed between the base portion and the blocking portion.

According to various embodiments of the disclosure, an electronic device may comprise a housing including a first housing and a second housing for guiding a slide of the first housing; a display including a first display area disposed on the first housing and a second display area extending from the first display area and configured to move at least a portion of the second display area based on the slide of the first housing; a supporting structure configured to support at least a portion of the first display area or at least a portion of the second display area and including a plurality of bars; and a blocking member disposed in the housing. The blocking member may include a base portion including at least a portion disposed on a seating structure formed in the second housing; a blocking portion configured to seal a gap between the display and the second housing, slidably coupled to the base portion, and to tightly contact at least a portion of the display; and an elastic portion disposed between the base portion and the blocking portion.

### [Advantageous Effects]

According to various embodiments of the disclosure, it is possible to block a foreign object from entering through a gap formed between the display and the housing of an electronic device.

According to various embodiments of the disclosure, when the housing or the display of the electronic device slides, the blocking portion is spaced apart from the display, thereby limiting friction between the blocking portion and the display.

Effects of the disclosure are not limited to the foregoing, and other unmentioned effects would be apparent to one of ordinary skill in the art from the following description.

### [Description of the Drawings]

FIG. 1 is a block diagram illustrating an electronic device in a network environment according to various embodiments;
FIG. 2A is a view illustrating a closed state of an electronic device according to various embodiments of the disclosure;
FIG. 2B is a view illustrating an opened state of an electronic device according to various embodiments of the disclosure;
FIG. 2C is a view illustrating an opened state of an electronic device according to various embodiments of the disclosure, as a state of the electronic device of FIG. 2B when viewed from a direction opposite to that of FIG. 2B;
FIG. 3 is a perspective view illustrating an electronic device according to various embodiments of the disclosure;
FIG. 4A is a cross-sectional view illustrating a closed state of an electronic device according to various embodiments of the disclosure;
FIG. 4B is a cross-sectional view illustrating an opened state of an electronic device according to various embodiments of the disclosure;
FIG. 5 is an exploded perspective view illustrating an electronic device and a blocking member according to various embodiments of the disclosure;
FIG. 6A is an exploded perspective view illustrating a blocking member according to various embodiments of the disclosure;
FIG. 6B is a coupled perspective view illustrating a blocking member according to various embodiments of the disclosure;
FIG. 6C is an enlarged view of portion A of FIG. 6B according to various embodiments of the disclosure;
FIG. 6D is an enlarged view of portion B of FIG. 6B according to various embodiments of the disclosure;
FIG. 6E is a cross-sectional view taken along line C-C' of FIG. 6B according to various embodiments of the disclosure;
FIG. 7A is a view illustrating a second display area and a supporting structure according to various embodiments of the disclosure;
FIG. 7B is a view illustrating a second display area and a supporting structure, as viewed from a direction opposite to that of FIG. 7A, according to various embodiments of the disclosure;
FIG. 7C is a perspective view illustrating a display and a supporting structure according to various embodiments of the disclosure;
FIG. 8A is a perspective view illustrating a blocking member and a supporting structure according to various embodiments of the disclosure;
FIG. 8B is a side view illustrating a blocking member and a supporting structure according to various embodiments of the disclosure;
FIG. 9A is a perspective view illustrating a blocking member and a supporting structure according to various embodiments of the disclosure;
FIG. 9B is a side view illustrating a blocking member and a supporting structure according to various embodiments of the disclosure;
FIG. 10 is a side view illustrating a blocking member and a supporting structure according to various embodiments of the disclosure;
FIG. 11 is a cross-sectional view illustrating a coupling relationship between a second plate and a blocking member according to various embodiments of the disclosure;
FIG. 12 is a view illustrating a second blocking portion and a second display area according to various embodiments of the disclosure;
FIG. 13 is a view illustrating a second blocking portion and a second display area according to various embodiments of the disclosure;
FIG. 14A is a view illustrating a closed state of an electronic device according to various embodiments of the disclosure;
FIG. 14B is a view illustrating an intermediate state of an electronic device according to various embodiments of the disclosure;
FIG. 14C is a view illustrating an opened state of an electronic device according to various embodiments of the disclosure;
FIG. 15A is a view illustrating a second display area and a supporting structure according to various embodiments of the disclosure; and
FIG. 15B is a view illustrating a second display area and a supporting structure, as viewed from a direction opposite to that of FIG. 15A, according to various embodiments of the disclosure.

### [Mode for Invention]

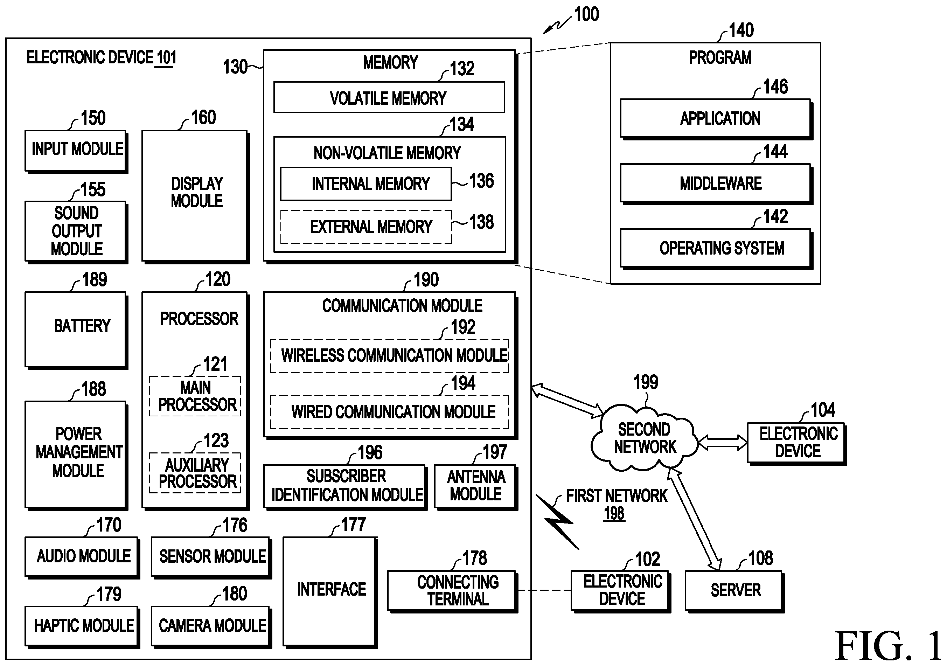

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

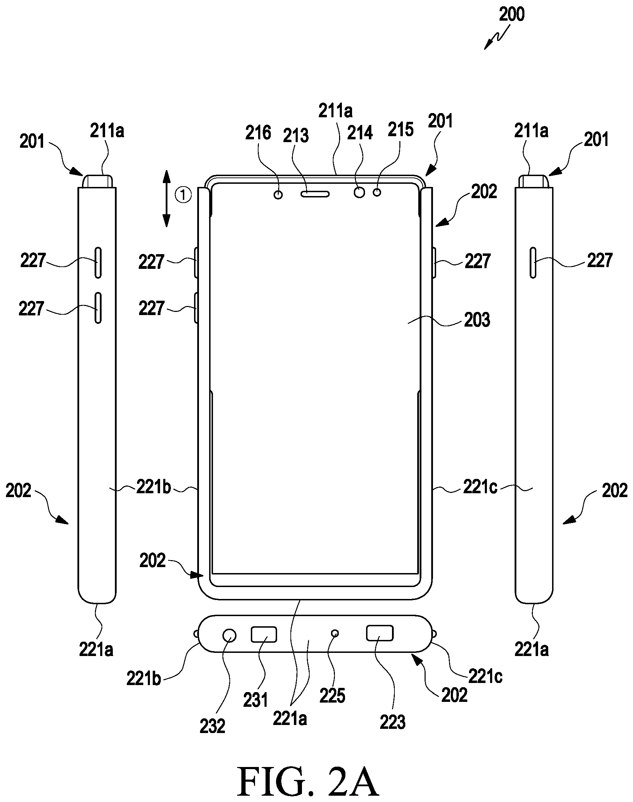

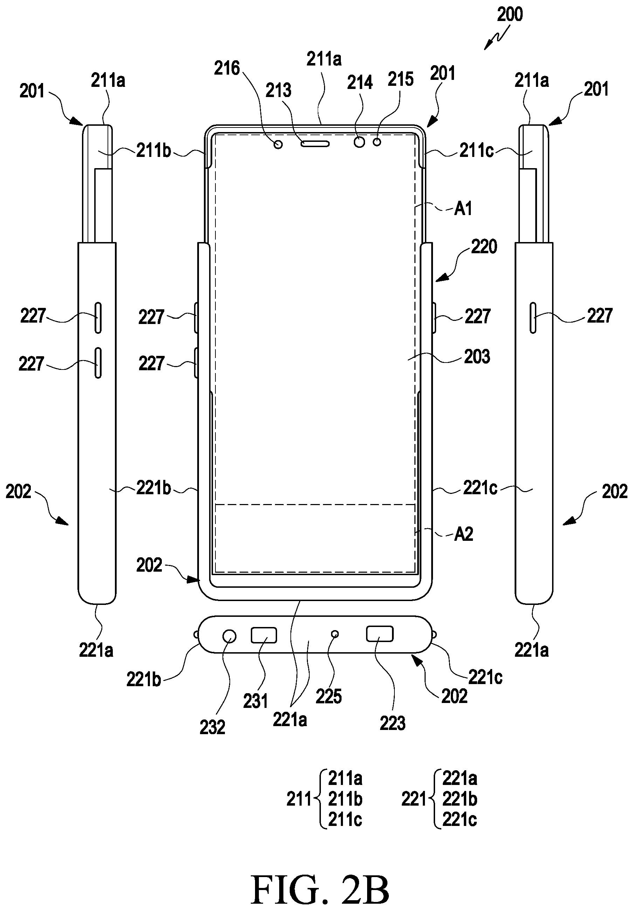

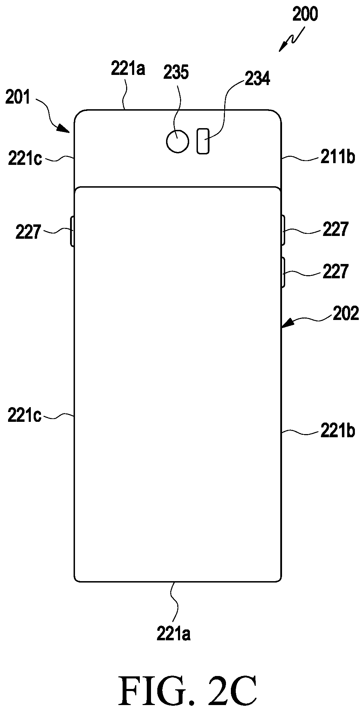

FIG. 2A is a view illustrating a closed state of an electronic device according to various embodiments of the disclosure. FIG. 2B is a view illustrating an opened state of an electronic device according to various embodiments of the disclosure. FIG. 2C is a view illustrating an opened state of an electronic device according to various embodiments of the disclosure, as a state of the electronic device of FIG. 2B when viewed from a direction opposite to that of FIG. 2B;

For example, FIG. 2A is a view illustrating a state in which a second display area A2 of a display 203 is received in a second housing 202. FIG. 2B is a view illustrating a state in which at least a portion of the second display area A2 is visually exposed to the outside of the second housing 202.

The state of the electronic device 200 illustrated in FIG. 2 may be referred to as a slide-in state or a first state of the electronic device 200 or the housings 201 and 202. For example, the first state may be defined as a closed state of the first housing 201 with respect to the second housing 202. The state of the electronic device 200 illustrated in FIG. 2B or 2C may be referred to as a slide-out state or a second state. For example, the second state may be defined as an opened state of the first housing 201 with respect to the second housing 202. According to an embodiment, the "closed state" may be defined and/or interpreted as a state in which the electronic device is closed, and the "opened state" may be defined and/or interpreted as a state in which the electronic device is opened.

Referring to FIGS. 2A to 2C, an electronic device 200 (e.g., the electronic device 101 of FIG. 1) may include housings 201 and 202 and/or a display 203. According to various embodiments, the housings 201 and 202 may include a second housing 202 and a first housing 201 that is disposed to be movable with respect to the second housing 202. According to an embodiment, the electronic device 200 may be interpreted as having a structure in which the second housing 202 is slidably disposed on the first housing 201. According to an embodiment, the first housing 201 may be disposed to perform reciprocating motion by a predetermined distance in a predetermined direction with respect to the second housing 202, for example, a direction indicated by an arrow ①. The configuration of the electronic device 200 of FIGS. 2A to 2C may be identical in whole or part to the configuration of the electronic device 101 of FIG. 1.

According to an embodiment, the first housing 201 may be referred to as, e.g., a first structure, a slide part, or a slide housing, and may be disposed to reciprocate on the second housing 202. In an embodiment, the first housing 201 may be movable relative to the second housing 202. According to an embodiment, the second housing 202 may be referred to as, e.g., a second structure, a main part, or a main housing. According to an embodiment, the second housing 202 may receive at least a portion of the first housing 201 and may guide the slide of the first housing 201. According to an embodiment, at least a portion (e.g., the first display area A1 or the second display area A2) of the display 203 may be visually exposed to the outside of the housings 201 and 202. According to an embodiment, the housings 201 and 202 may receive various electrical/electronic components, such as a main circuit board or a battery. In an embodiment, in the housings 201 and 202, a motor, a battery, a speaker, a sim socket, a sub circuit board electrically connected with a main circuit board, and/or the main circuit board having an application processor (AP), a communication processor (CP), or other electric components mounted thereon may be disposed.

According to an embodiment, the first housing 201 may include a first plate 211 (e.g., a slide plate or front structure). According to an embodiment, the first plate 201 may support at least a portion (e.g., the first display area A1) of the display 203. According to an embodiment, the first plate 211 may include first sidewalls 211a, 211b, and 211c to surround at least a portion of the display 203. According to an embodiment, the first sidewalls 211a, 211b, and 211c may include a 1-1th sidewall 211a, a 1-2th sidewall 211b extending from the 1-1th sidewall 211a, and a 1-3th sidewall 211c extending from the 1-1th sidewall 211a. The 1-3th sidewall 211c may be disposed substantially parallel to the 1-2th sidewall 211b. According to an embodiment, the 1-2th sidewall 211b and the 1-3th sidewall 211c may be formed or disposed substantially perpendicular to the 1-1th sidewall 211a.

According to an embodiment, in the closed state (e.g., FIG. 2) of the electronic device 200, the 1-2th sidewall 211b may face the 2-2th sidewall 221b of the second housing 202, and the 1-3th sidewall 211c may face the 2-3th sidewall 221c of the second housing 202. According to an embodiment, the first plate 211, the 1-1th sidewall 211a, the 1-2th sidewall 211b, and/or the 1-3th sidewall 211c may be integrally formed. According to another embodiment, the first plate 211, the 1-1th sidewall 211a, the 1-2th sidewall 211b, and/or the 1-3th sidewall 211c may be formed as separate housings and be combined or assembled.

According to various embodiments, the second housing 202 may be referred to as, e.g., a second structure, a main part, or a main housing. The second housing 202 may include a second plate 221 (e.g., a book cover).

According to various embodiments, the second plate 221 may include second sidewalls 221a, 221b, and 221c for surrounding at least a portion of the first housing 201 (or at least a portion of the first plate 211). According to an embodiment, the second sidewalls 221a, 221b, and 221c may include a 2-1th sidewall 221a, a 2-2th sidewall 221b extending from the 2-1th sidewall 221a, and a 2-3th sidewall 221c extending from the 2-1th sidewall 221a. The 2-3th sidewall 221c may be disposed substantially parallel to the 2-2th sidewall 221b. According to an embodiment, the 2-1th sidewall 221a may be substantially perpendicular to the 2-2th sidewall 221b and/or the 2-3th sidewall 221c. According to an embodiment, the 2-2th sidewall 221b may face the 1-2th sidewall 211b, and the 2-3th sidewall 221c may face the 1-3th sidewall 211c. For example, in the closed state (e.g., FIG. 2A) of the electronic device 101, the 2-2th sidewall 221b may cover at least a portion of the 1-2th sidewall 211b, and the 2-3th sidewall 221c may cover at least a portion of the 1-3th sidewall 211c. According to an embodiment, the second plate 221, the 2-1th sidewall 221a, the 2-2th sidewall 221b, and/or the 2-3th sidewall 221c may be integrally formed. According to another embodiment, the second plate 221, the 2-1th sidewall 221a, the 2-2th sidewall 221b, and/or the 2-3th sidewall 221c may be formed as separate housings and be combined or assembled.

According to various embodiments, the second plate 221 may be formed to have an open side (e.g., open front surface) to receive (or surround) at least a portion of the first plate 211. For example, the first housing 211 may be connected to the second plate 211 while being at least partially surrounded by the 2-1th sidewall 221a, the 2-2th sidewall 221b, and the 2-3th sidewall 221c and may be slid in the direction of arrow ① while being guided by the second housing 221. For example, the first housing 201 may be at least partially surrounded with respect to the second housing 202 and slide in the direction of arrow ① while being guided by the second housing 220.

According to various embodiments, the second plate 221 may be configured to cover at least a portion of the display 203. For example, at least a portion of the display 203 (e.g., the second display area A2) may be received in the second housing 202, and the second plate 221 and/or the 2-1th sidewall 221a may cover at least a portion (e.g., the second display area A2) of the display 203 received in the second housing 202.

According to various embodiments, the electronic device 200 may include a display 203. For example, the display 203 may be interpreted as a flexible display or a rollable display. According to an embodiment, at least a portion of the display 203 (e.g., the second display area A2) may slide based on the slide of the first housing 201.

According to an embodiment, the display 203 may include a first display area A1 and a second display area A2 configured to be exposed to the outside of the electronic device 200 based on the slide of the first housing 201 (or first plate 211).

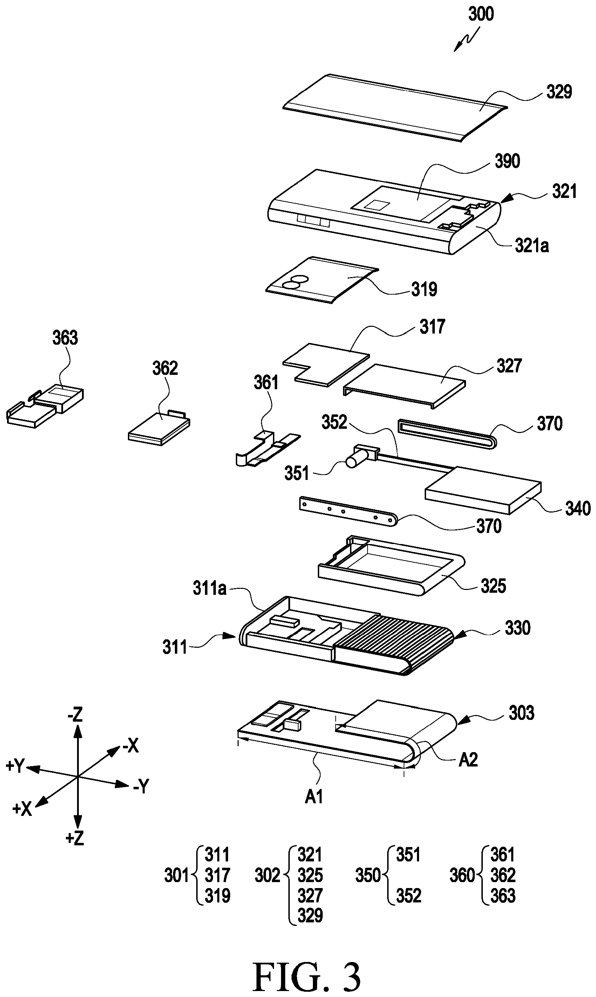

According to an embodiment, the display 203 may include, or be disposed adjacent to, a touch detection circuit, a pressure sensor capable of measuring the intensity (pressure) of a touch, and/or a digitizer that detects a magnetic field-type stylus pen. The configuration of the display 203 of FIGS. 2 and 3 may be identical in whole or part to the configuration of the display module 160 of FIG. 1.

According to various embodiments, the display 203 may include a first display area A1 and a second display area A2. According to an embodiment, the first display area A1 may be an area that is always visible from the outside of the electronic device 200. According to an embodiment, the first display area A1 may be interpreted as an area that cannot be positioned inside the first housing 201 and/or the second housing 202. According to an embodiment, the second display area A2 may extend from the first display area A1, and the second display area A2 may be inserted or received in, or visually exposed to the outside of, the second housing 202 as the first housing 201 slides.

According to various embodiments, the second display area A2 may be substantially moved while being guided by the supporting structure (e.g., the supporting structure 330 of FIG. 3) mounted in the second housing 202 and may be thus received in the second housing 202 or a space formed between the first housing 201 and the second housing 202 or be visually exposed to the outside of the electronic device 200. According to an embodiment, the second display area A2 may be moved based on the slide of the first housing 201 in the length direction (e.g., the direction indicated by the arrow ①). For example, at least a portion of the second display area A2 may be moved while being guided by the supporting structure (e.g., the supporting structure 330 of FIG. 3) based on the slide of the first housing 201. For example, at least a portion of the second display area A2 may be unfolded or rolled along with at least a portion of the supporting structure (e.g., the supporting structure 330 of FIG. 3).

According to various embodiments, when viewed from above the first housing 201, if the first housing 201 moves from the closed state to the opened state (e.g., from FIG. 2A to FIG. 2B), the second display area A2 may be gradually exposed to the outside of the housings 201 and 202 to be substantially coplanar with the first display area A1. In an embodiment, the second display area A2 may be at least partially received in the first housing 201 and/or the second housing 202. According to an embodiment, when viewed from above the first housing 201, if the first housing 201 moves from the opened state to the closed state (e.g., from FIG. 2B to FIG. 2A), the second display area A2 may be gradually received in the housings 201 and 202 while at least a portion of the second display area A2 may be rolled.

According to an embodiment, the first housing 201 may be moved in the opened state (refer to, e.g., FIG. 2B or 2C) and closed state (refer to, e.g., FIG. 2A) with respect to the second housing 202 in the first direction (e.g., direction of arrow ①) parallel to the second plate 221 and the second sidewall 221b. In the closed state, the first housing 201 may be placed at a first distance from the 2-1th sidewall 221a. In the opened state, the first housing 201 may move to be placed at a second distance larger than the first distance from the 2-1th sidewall 221a.

According to an embodiment, when viewed from above the first plate 211, if the first housing 201 moves from the closed state to the opened state, at least a portion of the bendable portion (e.g., the second display area A2) of the display 203 may be configured to form a substantially flat surface. According to an embodiment, the display 203 may include a flexible touchscreen display layer.

According to an embodiment, the audio modules 213, 223, and 225 may include speaker holes 213 and 223 and a microphone hole 225. The speaker holes 213 and 223 may include a receiver hole 213 or an external speaker hole 223. The microphone hole 225 may have a microphone inside to obtain external sounds. According to an embodiment, there may be a plurality of microphones to be able to detect the direction of a sound. According to an embodiment, the speaker holes 213 and 223 and the microphone hole 225 may be implemented as a single hole, or speakers may be included without the speaker holes 213 and 223 (e.g., piezo speakers). According to an embodiment, the receiver hole 213 may be disposed in the first housing 201. The external speaker hole 223 or the microphone hole 225 may be disposed in the second housing 202. According to another embodiment, the external speaker hole 223 may be disposed in the rear surface (e.g., the surface shown in FIG. 2C) of the first plate 211 or in a side surface of the first housing 201. According to an embodiment, the microphone hole 225 may be disposed on a side surface of the second housing 202.

According to an embodiment, the sensor modules 214 may generate an electrical signal or data value corresponding to an internal operating state or external environmental state of the electronic device 200. The sensor modules 214 may include a first sensor module 214 (e.g., a proximity sensor) disposed on, e.g., the front surface (e.g., the surface shown in FIG. 2A or 2B) of the first plate 211 and/or a second sensor module (e.g., a fingerprint sensor) (not shown) disposed on the rear surface (e.g., the surface shown in FIG. 2C) of the first plate 211 and/or a third sensor module 234 (e.g., an HRM sensor). The electronic device 200 may include a sensor module not shown, e.g., at least one of a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 215 and 235 may include a first camera module 215 disposed on the front surface (e.g., the surface shown in FIG. 2A or 2B) of the first plate 211 and a second camera module 235 disposed on the rear surface (e.g., the surface shown in FIG. 2C) of the first plate 211. The first camera module 215 or the second camera module 235 may include one or more lenses, an image sensor, and/or an image signal processor. According to an embodiment, the first camera module 215 disposed on the display 203 may be configured as an under display camera (UDC). According to an embodiment, the second camera module 235 may be disposed on one surface of the second housing 202 (or the second plate 221).

According to an embodiment, the key input device 227 may be disposed on the second sidewall 221b or the third sidewall 221c of the second housing 202. The electronic device 200 may include a key input device (not shown), e.g., a home key button or a touchpad disposed around the home key button. According to an embodiment, at least a portion of the key input device 227 may be positioned in an area of the first housing 201 and/or the second housing 202.

According to an embodiment, the indicator 216 may be disposed on the front surface (e.g., the surface shown in FIG. 2A or FIG. 2C) of the first plate 211. The indicator 216 may provide, e.g., state information about the electronic device 200 in the form of light and may include an LED.

According to an embodiment, the connector holes 231 and 232 may include, e.g., a first connector hole 231 for receiving a connector (e.g., a universal serial bus (USB) connector) for transmitting or receiving power and/or data to/from an external electronic device and/or a second connector hole (e.g., an earphone jack) 232 for receiving a connector for transmitting or receiving audio signals to/from the external electronic device. According to an embodiment, the first connector hole 231 or the second connector hole 232 may be disposed or formed on the first sidewall 221a of the second housing 202 or the second plate 221. According to an embodiment, the first connector hole 231 or the second connector hole 232 may be omitted.

FIGS. 3 to 15B illustrate a spatial coordinate system for convenience of description. As illustrated in FIGS. 3 to 15B, the X-axis direction may be defined and interpreted as the width direction of the electronic device and components of the electronic device, the Y-axis direction may be defined and interpreted as the length direction of the electronic device and components of the electronic device or the sliding direction of the electronic device and components of the electronic device, and the Z-axis direction may be defined and interpreted as the thickness direction of the electronic device and components of the electronic device.

FIG. 3 is a perspective view illustrating an electronic device according to various embodiments of the disclosure.

Referring to FIG. 3, an electronic device 300 (e.g., the electronic device 101 of FIG. 1 or the electronic device 200 of FIG. 2A) may include a first housing 301, a second housing 302, a display 303, a battery 340, a printed circuit board 360, a guide rail 370, and/or a motor structure 350.

The configuration of the first housing 301, the second housing 302, and/or the display 303 of FIG. 3 may be identical in whole or part to the configuration of the first housing 201, the second housing 202, and/or the display 203 of FIGS. 2A to 2C.

According to various embodiments, the first housing 301 (e.g., the first housing 201 of FIGS. 2A to 2C) may include a first plate 311 (e.g., the first plate 311 of FIGS. 2A to 2C), a rear cover 317 and/or a first back cover 319.

According to various embodiments, the second housing 302 (e.g., the second housing 202 of FIGS. 2A to 2C) may include a second plate 321 (e.g., the second plate 321 of FIGS. 2A to 2C), a guide frame 325, a battery plate 327, and/or a second back cover 329.

In an embodiment, the components 311, 317, and 319 of the first housing 301 may be interpreted as components that move relative to the second housing 302 according to the slide (e.g., opening operation or closing operation) of the electronic device 300. In an embodiment, the components 321, 325, 327, and 329 of the second housing 302 may be interpreted as components that have a fixed position or arrangement with respect to the components 311, 317, and 319 of the first housing 301 which relatively move according to the slide (e.g., opening operation or closing operation) of the electronic device 300.

According to an embodiment, at least a portion of the display 303 (e.g., the display 203 of FIGS. 2A to 2C) may be disposed inside the first housing 301 and/or second housing 302 or in an internal space formed as they are coupled together. According to an embodiment, the display 303 may include a first display area A1 (e.g., the first display area A1 of FIG. 2B) disposed on the first housing 301 or the first plate 311 and a second display area A2 (e.g., the second display area A2 of FIG. 2B) extending from the first display area A1.

According to an embodiment, the second display area A2 may be an area in which at least a portion of the display 303 is bent. According to an embodiment, the first display area A1 may be disposed on one surface (e.g., the surface facing in the +Z direction of FIG. 3) of the first plate 311 and be visually exposed to the outside of the electronic device 300. The second display area A2 may be disposed between the first plate 311 and the second plate 321 not to be visually exposed to the outside of the electronic device 300 in the closed state (e.g., FIG. 2A) of the electronic device 300. The second display area A2 may be visually exposed to the outside of the electronic device 300 in the opened state (e.g., FIG. 2B) of the electronic device 300.

For example, when the first plate 311 and/or the first housing 301 slides in the slide-out direction (e.g., +Y direction of FIG. 3) with respect to the second plate 321 and/or the second housing 302, the second display area A2, along with the first display area A1, may slide in the sliding direction (e.g., +Y direction of FIG. 3), and the second display area A2 may be visually exposed to the outside of the electronic device 300.

For example, when the first plate 311 and/or the first housing 301 slides in the slide-in direction (e.g., -Y direction of FIG. 3) with respect to the second plate 321 and/or the second housing 302, the second display area A2, along with the first display area A1, may slide in the sliding direction (e.g., -Y direction of FIG. 3), and at least a portion of the second display area A2 may be received in a rolled shape between the first plate 311 and the second plate 321.

According to an embodiment, the first plate 311 may be formed of a metal material and/or a non-metal (e.g., polymer) material. The first plate 311 may have one surface (e.g., the surface facing in the +Z direction of FIG. 3) where at least a portion of the display 303 may be disposed and the other surface (e.g., the surface facing in the -Z direction of FIG. 3) where the printed circuit board 360 may be disposed.

According to an embodiment, the second plate 321 may be formed to surround or cover at least a portion of the first plate 311 or the display 303. According to an embodiment, the second back cover 329 may be configured to cover at least a portion of one surface (e.g., the face facing in the -Z direction of FIG. 3) of the second plate 321.

According to an embodiment, an electric component 390 (e.g., a near-field communication (NFC) antenna, a magnetic secure transmission (MST) antenna, a wireless charging module (WCM), or a printed circuit board) may be disposed and/or mounted on the surface (e.g., the surface facing in the -Z direction of FIG. 3) of the second plate 321, and the second back cover 329 may be configured to cover the electric component.

According to an embodiment, the back cover 280 may include a non-light transmissive material. According to another embodiment, the back cover 280 may be formed of a light-transmissive material.

According to an embodiment, the guide frame 325 may be disposed in the second plate 321. According to an embodiment, the guide frame 325 may receive the battery 340. According to an embodiment, the battery 340 may be electrically connected with the printed circuit board 360 or various electric components to feed power to the printed circuit board 360 or the electric components.

According to an embodiment, the battery 340 may be disposed in the groove formed in the guide frame 325. According to an embodiment, the battery plate 327 may be disposed on one surface (e.g., the face facing in the -Z direction of FIG. 3) of the battery 340 to protect the battery 340.

According to an embodiment, the rear cover 317 may be disposed on one side of the battery plate 327. According to an embodiment, the rear cover 317 may be slide by following the slide of the first plate 311. According to an embodiment, the rear cover 317 may be fixed to the first plate 311.

According to an embodiment, the first back cover 319 may be fixed to the rear cover 317 or the first plate 311. The first back cover 319 may be slide by following the slide of the first plate 311.

According to an embodiment, the guide rail 370 may guide the movement of the display 303. The guide rail 370 may be coupled to the guide frame 325 and/or the second plate 311.

According to an embodiment, the supporting structure 330 (or multi-bar structure 330) may support the display 303. According to an embodiment, the supporting structure 330 may support at least a portion of the first display area A1 or at least a portion of the second display area A2. For example, the supporting structure 330 may be connected with the display 303. For example, the supporting structure 330 may be adhered to the display 303 through an adhesive and/or an adhesive tape. According to an embodiment, at least a portion of the display 303 and the supporting structure 330 may be positioned between the first plate 311 and the second plate 321. According to an embodiment, as the first housing 301 slides, the supporting structure 303 may move with respect to the second housing 302. In the closed state (e.g., FIG. 2A), most of the supporting structure 330 may be received in the second housing 302 or the second plate 321.

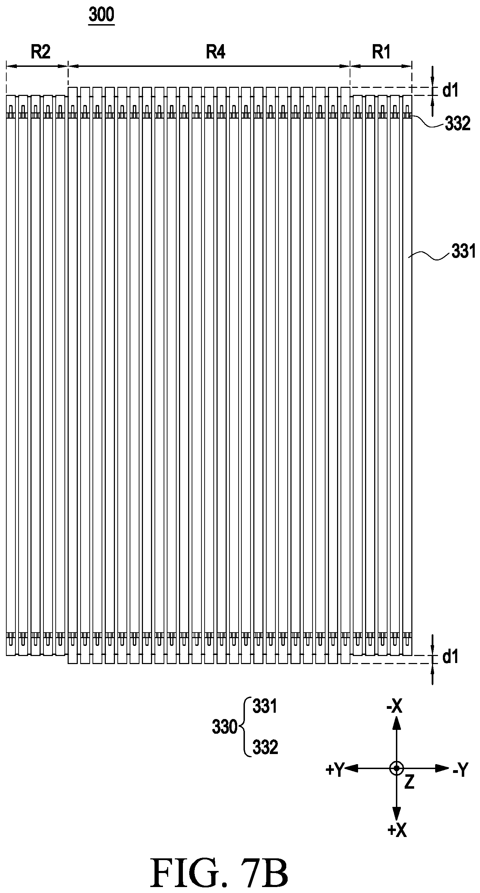

According to various embodiments, the supporting structure 330 may include a plurality of bars (e.g., the bars 331 of FIG. 7B) (or rods). The plurality of bars may extend in a straight line. According to various embodiments, each bar may slide along a groove formed in the guide rail 370 while remaining parallel to another adjacent bar. According to an embodiment, as the first housing 311 slides, the plurality of bars may be arranged to form a curved shape or a flat shape. For example, as the first plate 311 slides, a portion of the supporting structure 330 that faces the 2-1th sidewall 321a (e.g., the 2-1th sidewall 221a of FIGS. 2A to 2C) may form a curved surface while another portion of the supporting structure 330 that does not face it may form a flat surface.

According to an embodiment, the second display area A2 of the display 303 may be mounted or supported on the supporting structure 330, and in the opened state (e.g., FIG. 2B), at least a portion of the second display area A2, along with the first display area A1, may be exposed to the outside of the second housing 302 or the outside of the second plate 321. In the state in which the second display area A2 is exposed to the outside of the second housing 202, the supporting structure 330 may substantially form a flat surface, thereby supporting or maintaining the second display area A2 in the flat state. According to an embodiment, the supporting structure 330 may be replaced with a bendable integral supporting member (not shown). According to an embodiment, the supporting structure 330 may be interpreted as a display supporting multi-bar, a multi-bar structure, or an articulated hinge structure.

According to various embodiments, the guide rail 370 may guide the movement of the plurality of bars. According to an embodiment, the guide rail 370 may include a groove-shaped rail formed inside the guide rail 370 and a protrusion positioned inside the guide rail. At least a portion of the protrusion may be surrounded by the rail. According to an embodiment, the supporting structure 330 may move while remaining fitted to the groove-shaped rail. For example, the plurality of bars may slide along the rail while being fitted in the groove-shaped rail.

According to an embodiment, when the electronic device 300 is opened (e.g., a slide-out operation), the size of the area where the display 303 is exposed to the outside may be increased. For example, by the driving of the motor 351 of the motor structure 350 (e.g., driving for sliding out the display) and/or the external force provided by the user, the first plate 311 connected with the motor 351 may be slid out, and the plurality of bars of the supporting structure 330 may be slid out along the rail of the guide rail 370. For example, the rolled portion of the supporting structure 330 may be flattened. Accordingly, the second display area A2 which is received between the first plate 311 and the second plate 321 may be exposed to the front surface of the second display area A2.

According to an embodiment, when the electronic device 300 is closed (e.g., a slide-in operation), the size of the area where the display 303 is exposed to the outside may be reduced. For example, by the driving of the motor 351 (e.g., driving for sliding in the display) and/or the external force provided by the user, the first plate 311 where the motor 351 is disposed may be slid in, and the plurality of bars of the supporting structure 330 may be slid in along the rail of the guide rail 370. For example, the flattened portion of the supporting structure 330 may be rolled. Accordingly, the extended second display area A2 may be rolled and received between the first plate 311 and the second plate 321.

According to an embodiment, the motor structure 350 may include a motor 351 including a pinion gear and a rack gear 352. According to an embodiment, the motor 351 may be coupled to the first plate 311, and the rack gear 352 may be coupled to the guide frame 325. According to an embodiment, the rack gear 352 may be coupled to the second plate 321. According to an embodiment, the motor 351 may be coupled to the guide frame 325 or the second plate 321, and the rack gear 352 may be coupled to the first plate 311.

According to an embodiment, as the pinion gear of the motor 351 is rotated in one direction on the rack gear 352, the first plate 311 may slide in the first sliding direction (e.g., +Y direction of FIG. 3) with respect to the second plate 321. According to an embodiment, as the pinion gear of the motor 351 rotates in the other direction opposite to the one direction on the rack gear 352, the first plate 311 may slide in the sliding direction (e.g., the -Y direction of FIG. 3) with respect to the second plate 321.

According to an embodiment, the printed circuit board 360 may include a first printed circuit board 361, a second printed circuit board 362, and a third printed circuit board 363. According to an embodiment, the printed circuit board 360 may be disposed on the first plate 311 or the second plate 321.

According to an embodiment, the first printed circuit board 361 may be a power printed circuit board (PCB). The first printed circuit board 361 may be electrically connected to the battery 340 and receive power from the battery 340, and supply power to other electric components directly or indirectly electrically connected to the first printed circuit board 361. Further, the first printed circuit board 361 may transfer various signals (e.g., commands or data) between various electric components.

According to an embodiment, a processor (e.g., the processor 120 of FIG. 1), a memory (e.g., the memory 130 of FIG. 1), and/or an interface (e.g., the interface 177 of FIG. 1) may be mounted on the second printed circuit board 362. The processor may include one or more of, e.g., a central processing unit, an application processor, a graphic processing device, an image signal processing, a sensor hub processor, or a communication processor.

According to an embodiment, the third printed circuit board 363 may be disposed inside the first plate 311. The third printed circuit board 363 may move by following the movement of the first plate 311. The third printed circuit board 363 may include various electric components. According to an embodiment, the third printed circuit board 363 may be electrically connected to a camera module (e.g., the camera modules 215 and 235 of FIGS. 2A to 2C).

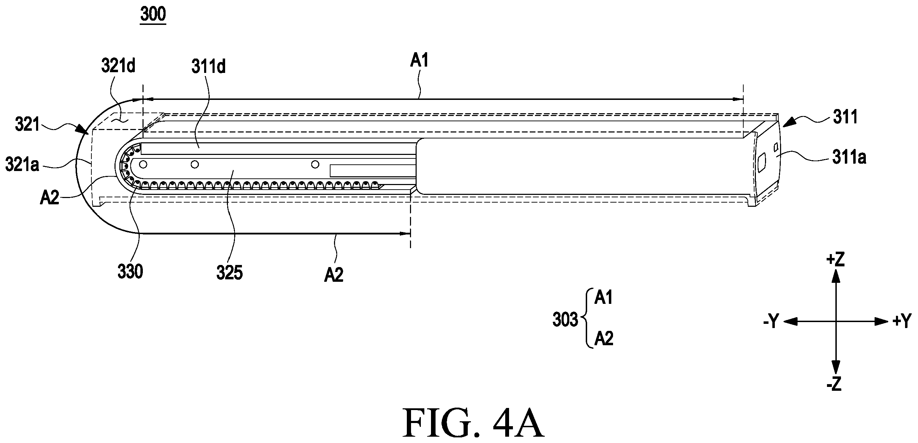

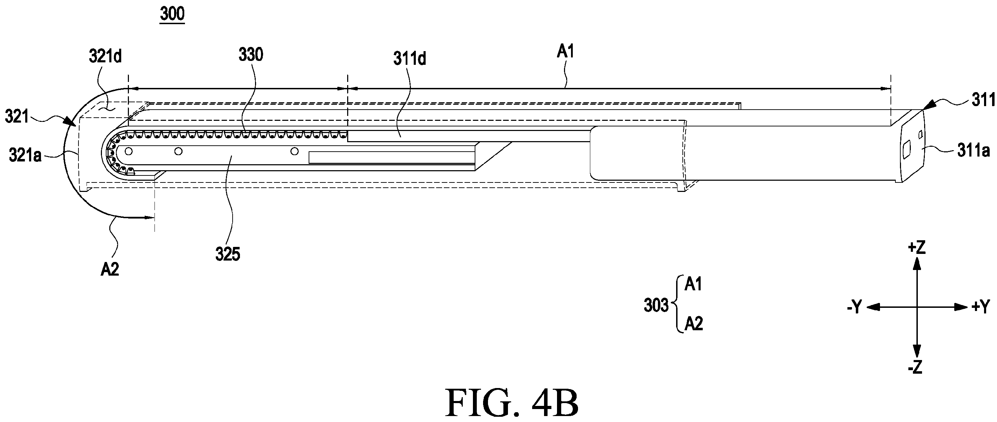

FIG. 4A is a cross-sectional view illustrating a closed state of an electronic device according to various embodiments of the disclosure. FIG. 4B is a cross-sectional view illustrating an opened state of an electronic device according to various embodiments of the disclosure.

Referring to FIGS. 4A and 4B, an electronic device 300 (e.g., the electronic device 300 of FIG. 3) may include a first plate 311, a second plate 321, a display 303, a guide frame 325, and/or a supporting structure 330.

The configuration of the first plate 311, the second plate 321, the display 303, the guide frame 325 and/or the supporting structure 330 of FIGS. 4A and 4B may be identical in whole or part to the configuration of the first plate 311, the second plate 321, the display 303, the guide frame 325 and/or the supporting structure 330 of FIG. 3.

FIG. 4A illustrates a closed state of the electronic device 300. FIG. 4B illustrates an opened state of the electronic device 300.

When the electronic device 300 changes from the closed state (e.g., FIG. 4A) to the opened state (e.g., FIG. 4B), the first plate 311 may slide in a first sliding direction (e.g., +Y direction of FIGS. 4A and 4B) with respect to the second plate 321. According to an embodiment, at least one portion of the first display area A1 (e.g., the first display area A1 of FIG. 3) may be coupled to at least a portion 311d of the first plate 311. The first display area A1 may slide along with the first plate 311.

When the electronic device 300 is in the closed state (e.g., FIG. 4A), the second display area A2 may have a shape in which at least a portion thereof is rolled up. According to an embodiment, when the electronic device 300 changes from the closed state to the opened state, the second display area A2, along with the first display area A1, may slide in the first sliding direction. The second display area A2 may be supported by a supporting structure 330. The second display area A2 may be supported by the supporting structure 330, and the rolled portion of the second display area A2 may be flattened to form a flat surface with the first display area A1.

According to an embodiment, the supporting structure 330 may be moved along a guide rail (e.g., the guide rail 330 of FIG. 3) coupled to the guide frame 325 and support the second display area A2.

When the electronic device 300 changes from the opened state (e.g., FIG. 4B) to the closed state (e.g., FIG. 4A), the first plate 311 may slide in a second sliding direction (e.g., -Y direction of FIGS. 4A and 4B) with respect to the second plate 321. According to an embodiment, the first display area A1 may slide along with the first plate 311.

When the electronic device 300 is in the opened state (e.g., FIG. 4B), the second display area A2 may have a shape in which at least a portion thereof has been flattened. According to an embodiment, when the electronic device 300 changes from the opened state to the closed state, the second display area A2, along with the first display area A1, may slide in the second sliding direction. The second display area A2 may be supported by the supporting structure 330, and the flattened portion of the second display area A2 may be rolled to form a curved surface with respect to the first display area A1.

According to an embodiment, the second plate 321 may include a front surface 321d that covers the rolled portion of the second display area A2. According to an embodiment, the front surface 321d of the second plate 321 may cover the rolled portion of the second display area A2 to thereby limit exposure of the rolled portion of the second display area A2 to the outside.

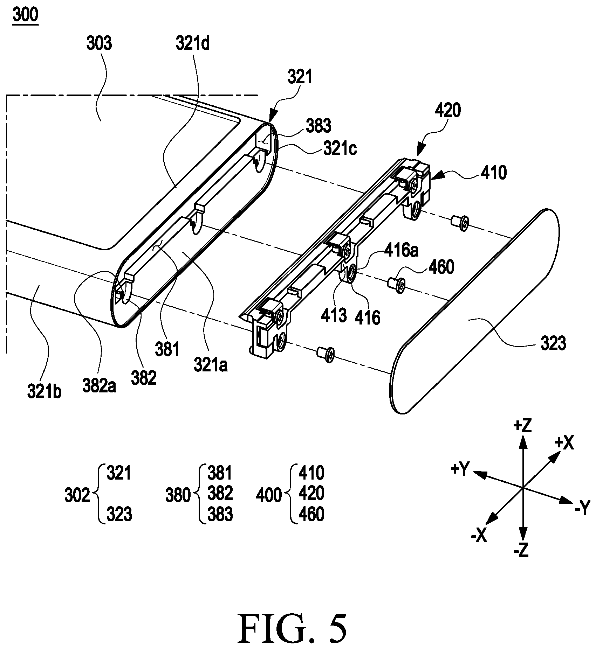

Referring to FIGS. 4A and 4B, a predetermined gap may be formed between the front surface 321d of the second plate 321 and at least a portion of the second display area A2. For example, if an end of the front surface 321d (e.g., the end facing in the +Y direction of FIGS. 4A and 4B) contacts the second display area A2, when the second display area A2 slides, the second display area A2 may be scratched by the end of the front surface 321d. To prevent this, the front surface 321d of the second plate 321 needs to form a predetermined gap from at least a portion of the second display area A2. According to various embodiments of the disclosure, to seal the predetermined gap, a blocking portion 420 of a blocking member (e.g., the blocking member 400 of FIG. 5) is provided which tightly contacts the second display area A2 or is spaced apart from the second display area A2.

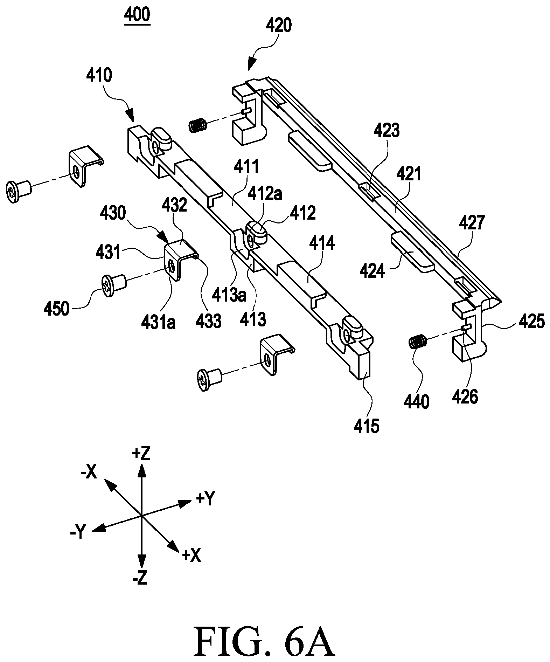

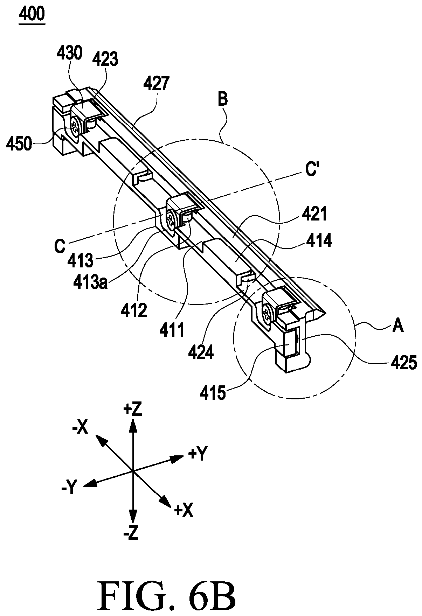

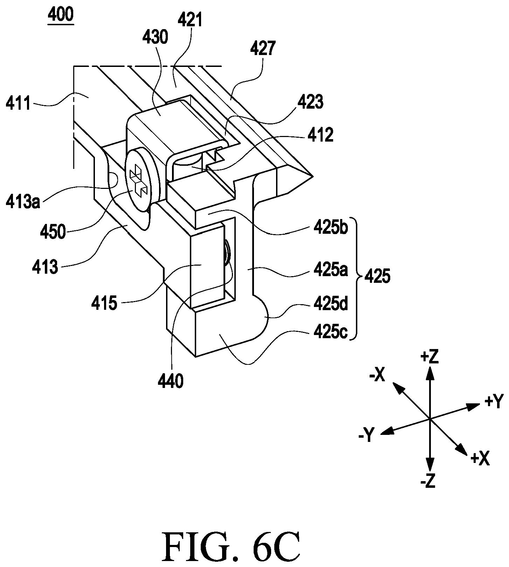

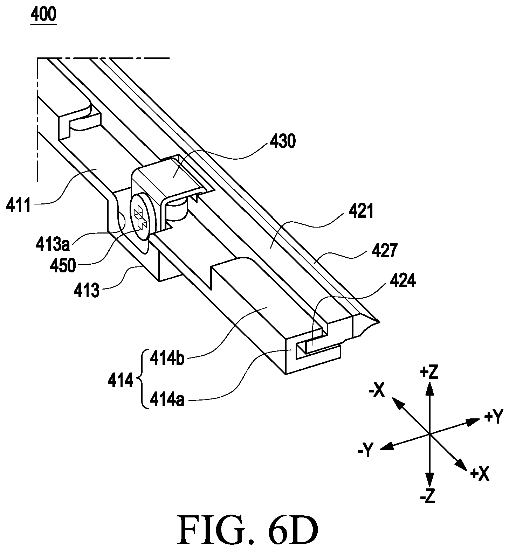

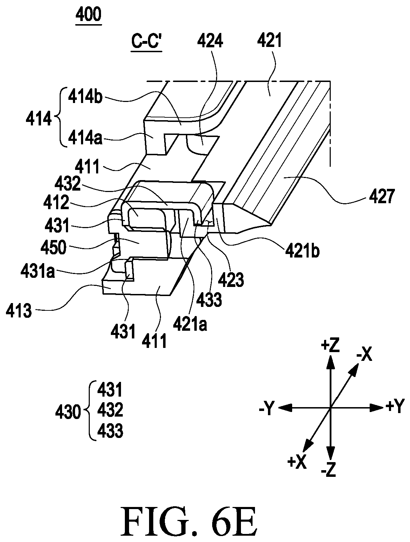

FIG. 5 is an exploded perspective view illustrating an electronic device and a blocking member according to various embodiments of the disclosure. FIG. 6A is an exploded perspective view illustrating a blocking member according to various embodiments of the disclosure. FIG. 6B is a coupled perspective view illustrating a blocking member according to various embodiments of the disclosure. FIG. 6C is an enlarged view of portion A of FIG. 6B according to various embodiments of the disclosure. FIG. 6D is an enlarged view of portion B of FIG. 6B according to various embodiments of the disclosure. FIG. 6E is a cross-sectional view taken along line C-C' of FIG. 6B according to various embodiments of the disclosure.

Referring to FIGS. 5 and 6, an electronic device 300 (e.g., the electronic device 300 of FIGS. 3 to 4B) may include a second housing 302, a display 303, and/or a blocking member 400.

The configuration of the second housing 302 and/or the display 303 of FIGS. 5 to 6E may be identical in whole or part to the configuration of the second housing 302 and/or the display 303 of FIGS. 3 to 4B.

According to various embodiments, the second plate 321 (e.g., the second plate 321 of FIGS. 3 to 4B) may include a seating structure 380 formed on the 2-1th sidewall 321a (e.g., the 2-1th sidewall 221a of FIGS. 2A to 2C or the 2-1th sidewall 321a of FIGS. 3 to 4B).

According to an embodiment, the seating structure 380 may be a space constituted of an opening formed through the 2-1th sidewall 321a and a groove depressed in the 2-1th sidewall 321a. According to an embodiment, the blocking member 400 may be inserted into the seating structure 380.

According to an embodiment, the seating structure 380 may include a first opening 381 formed through the 2-1th sidewall 321a and extending in the width direction (e.g., the X-axis direction of FIG. 5) of the second plate 321. The first opening 381 may provide a space into which the blocking member 400 may be inserted.

According to an embodiment, the seating structure 380 may include a groove-shaped first seating groove 382 depressed in the 2-1th sidewall 321a. According to an embodiment, the first seating groove 382 may further include a first seating hole 382a formed through at least a portion of the 2-1th sidewall 321a forming the first seating groove 382. The first seating groove 382 may be connected to the first opening 381. The fifth protrusion 416 of the base portion 410 of the blocking member 400 may be inserted into the first seating groove 382. The fifth protrusion 416 may be coupled to the first seating groove 382 through the fifth hole 416a formed in the fifth protrusion 416 and the second bolt 450 inserted into the first seating hole 382a while being inserted in the first seating groove 382.

According to various embodiments, the seating structure 380 may further include a second opening 383 connected with the first opening 381. The second openings 383 may be formed on two opposite ends of the first opening 381 and be portions formed through the 2-1th sidewall 321a. According to an embodiment, the second guide portion 425 (refer to FIG. 6A) of the blocking member 400 may be inserted into the second opening 383.

According to various embodiments, the blocking member 400 may include a base portion 410, a blocking portion 420, a cover portion 430, an elastic portion 440, a first bolt 450, and a second bolt 460.

According to an embodiment, at least a portion of the base portion 410 may be coupled to the housing (e.g., the second plate 321 of FIG. 5). According to an embodiment, the base portion 410 may be inserted into the first opening 381 formed in the second plate 321.

According to an embodiment, the base portion 410 may include a first extension member 411, a first protrusion 412, a second protrusion 413, a third protrusion 414, a fourth protrusion 415, and a fifth protrusion 416.

According to an embodiment, the first extension member 411 may extend in the width direction (e.g., the X-axis direction of FIG. 5) of the electronic device 300. According to an embodiment, the first extension member 411 may be a portion forming the body of the base portion 410.

According to an embodiment, the first protrusion 412 may be a portion protruding from at least one portion of the upper surface (e.g., the surface facing in the +Z direction in FIG. 6A) of the first extension member 411. According to an embodiment, the first protrusion 412 may include a first hole 412a formed through the first protrusion 412 in the sliding direction (e.g., the Y-axis direction of FIG. 6A).

According to an embodiment, the second protrusion 413 may be a portion protruding from at least one portion of the lower surface (e.g., the surface facing in the -Z direction in FIG. 6A) of the first extension member 411. According to an embodiment, the second protrusions 413 may be provided in a number corresponding to the first protrusions 412 and may have positions corresponding to the first protrusions 412.

According to an embodiment, the second protrusion 413 may further include a first recess 413a (or a fixing recess) that is depressed from a portion of the first extension member 411 where the second protrusion 413 is disposed.

According to an embodiment, the third protrusion 414 is formed to protrude from a portion where the first protrusion 412 is not formed in the upper surface (e.g., the surface facing in the +Z direction in FIG. 6A) of the first extension member 411. According to an embodiment, the third protrusion 414 may include a 3-1th protrusion 414a (refer to FIG. 6D) extending upwardly from the first extension member 411 and a 3-2th protrusion 414b (refer to FIG. 6D) extending from the upper end of the 3-1th protrusion 414a in the first sliding direction (e.g., the +Y direction in FIG. 6D). The 3-2th protrusion 414b, along with the 3-1th protrusion 414a, may form a predetermined space between them and the first extension member 411.

According to an embodiment, the fourth protrusions 415 may be portions protruding from two opposite ends of the first extension member 411. In an embodiment, the length or thickness of the fourth protrusion 415 (e.g., the length or thickness in the Y-axis direction of FIG. 6A) may be provided to be smaller than the length or thickness of the first extension member 411 (e.g., the length or thickness in the Y-axis direction of FIG. 6A). In another embodiment, the length of the fourth protrusion 415 may be larger than or substantially equal to the length of the first extension member 411.

According to an embodiment, the fifth protrusion 416 may be formed to protrude from the second protrusion 413 (refer to, e.g., FIG. 5). According to an embodiment, the fifth protrusion 416 may include a fifth hole 416a formed through the fifth protrusion 416 in the sliding direction (e.g., the Y-axis direction of FIG. 5). Referring to FIGS. 6A to 6E, although the fifth protrusion 416 of FIG. 5 is not shown, it should be understood that the blocking member 400 includes the fifth protrusion 416.

According to an embodiment, the blocking portion 420 may include a first blocking portion 421 and a second blocking portion 427.

According to an embodiment, the first blocking portion 421 may be formed to extend in the width direction (e.g., the X-axis direction of FIG. 6A) of the electronic device 300. The first blocking portion 421 may be a portion forming the body of the blocking portion 420.

According to an embodiment, the first blocking portion 421 may include a second recess 423 depressed in at least a portion of the upper surface (e.g., the surface facing in the +Z direction in FIG. 6A) of the first blocking portion 421.

According to an embodiment, the first blocking portion 421 may include a first guide portion 424 formed to protrude from the surface of the first blocking portion 421 facing the base portion 410. The first guide portion 424 may be inserted into the space formed by the third protrusion 414. The first guide portions 424 may be included as many as the number of third protrusions 414.

According to an embodiment, the first blocking portion 421 may further include second guide portions 425 formed at two opposite ends of the first blocking portion 421. According to an embodiment, the second guide portion 425 may include a second upper guide portion 425b protruding from the first blocking portion 421, a second lower guide portion 425c spaced apart from the second upper guide portion 425b, a second connecting portion 425a connecting the second upper guide portion 425b and the second lower guide portion 425c, and a sixth protrusion 425d protruding from the second connecting portion 425a and/or the second lower guide portion 425c. According to an embodiment, the fourth protrusion 415 of the base portion 410 may be inserted in the space formed by the second upper guide portion 425b, the second lower guide portion 425c, and the second connecting portion 425a.

According to an embodiment, the first blocking portion 421 may further include a guide pin 426 protruding from the second connecting portion 425a. According to an embodiment, the guide pin 426 may be inserted into the elastic portion 440. According to an embodiment, the elastic portion 440 may be a spring member.

The second blocking portion 427 may be coupled to a front surface (e.g., the surface facing the Y direction of FIG. 6A) of the first blocking portion 421. According to an embodiment, the second blocking portion 427 may include a silicone member or a rubber member.

According to an embodiment, the cover portion 430 may include a fixing portion 431 fixed to the first recess 413a, an extension 432 extending from the fixing portion 431, and a bending portion 433 bent from the extension 432.

The fixing portion 431 may be inserted into the first recess 413a (or fixing recess) and may further include a fixing hole 431a formed through the fixing portion 431.

According to an embodiment, the fixing portion 431 may be fixed to the first recess 413a and/or the first protrusion 412 through the first bolt 450 while being inserted into the first recess 413a. For example, the first bolt 450 may be inserted and fixed into the fixing hole 431a and the first hole 412a.

According to an embodiment, the second housing 302 may further include a deco member 323. The deco member 323 may be formed of, e.g., a metal and/or non-metal material (e.g., polymer). The decor member 323 may be coupled to the second plate 321 to cover the 2-1th sidewall 321a of the second plate 321. The decor member 323 may cover and protect the blocking member 400 so that the blocking member 400 is not exposed to the outside of the electronic device 300.

Referring to FIGS. 6A to 6E, the blocking portion 420 of the blocking member 400 may be coupled to the base portion 410 to be slidable with respect to the base portion 410. According to an embodiment, the fourth protrusion 415 of the base portion 410 may be inserted into the space formed by the second guide portion 425 of the blocking portion 420. According to an embodiment, the first guide portion 424 of the blocking portion 420 may be inserted into the space formed by the third protrusion 414 of the base portion 410.

According to an embodiment, in the cover portion 430, the fixing portion 421 may be fixed to the first recess 413 or the first protrusion 412, and the extension 412 may face or be in tight contact with the upper surface of the first protrusion 412, and the bending portion 433 may be inserted into the second recess 423.

Referring to FIG. 5, in the base portion 410, the fifth protrusion 416 is fixed to the first seating groove 382 of the second plate 321, so that the base portion 410 may have a fixed position with respect to the second plate 321.

Referring to FIG. 6C, in the blocking portion 420, the second upper guide portion 425b and the second lower guide portion 425c of the second guide portion 425 may be disposed to face the fourth protrusion 415 of the base portion 410. Accordingly, when the blocking portion 420 slides in the sliding direction (e.g., the Y-axis direction in FIG. 6c) with respect to the base portion 410, the blocking portion 420 may be limited from tilting with respect to the base portion 410.

Referring to FIG. 6D, in the blocking portion 420, the first guide portion 424 may be inserted into the space formed by the 3-1th protrusion 414a and the 3-2th protrusion 414b of the base portion 410. Accordingly, when the blocking portion 420 is moved in the sliding direction (e.g., the Y-axis direction in FIG. 6D) with respect to the base portion 410, tilting of the blocking portion 420 with respect to the base portion may be restricted.

Referring to FIG. 6E, in the cover portion 430, the bending portion 433 may be inserted into the second recess 423 of the first blocking portion 421. When the blocking portion 420 slides in the first sliding direction (e.g., the +Y direction in FIG. 6E) with respect to the base portion 410, the bending portion 433 of the cover portion 430 may be stuck to a side portion 421a of the first blocking portion 421 constituting the second recess 423. Accordingly, when the blocking portion 420 is slid by the elastic portion (e.g., the elastic portion 440 of FIG. 6A), the sliding distance of the blocking portion 420 may be limited by the bending portion 433 of the cover portion 430, and the blocking portion 420 may be restricted from escaping off the base portion 410.

According to an embodiment, the elastic portion 440 may be disposed between the base portion 410 and the blocking portion 420. For example, the elastic portion 440 may be disposed between the fourth protrusion 415 of the base portion 410 and the second guide portion 425 of the blocking portion 421. According to an embodiment, the elastic portion 440 may be pressurized by being pressed by the second guide portion 425 when the blocking portion 420 is moved in the second sliding direction (e.g., the -Y direction in FIG. 6A). According to an embodiment, the elastic portion 440 may be elastically restored so that the blocking portion 420 may be slid in the first sliding direction (e.g., the +Y direction in FIG. 6A) and pressurize the second guide portion 425.

According to an embodiment, the second blocking portion 427 may be in tight contact with or spaced apart from at least a portion of the display 303 (e.g., the second display area A2 of FIG. 3).

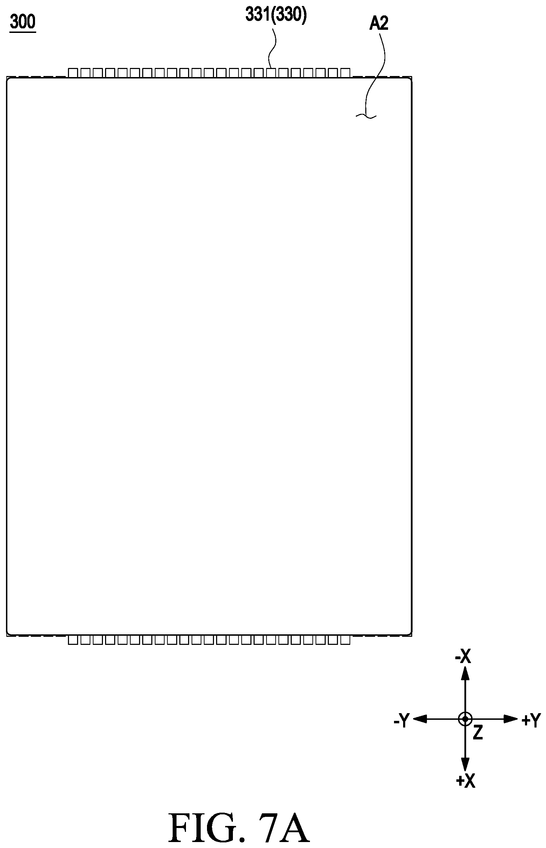

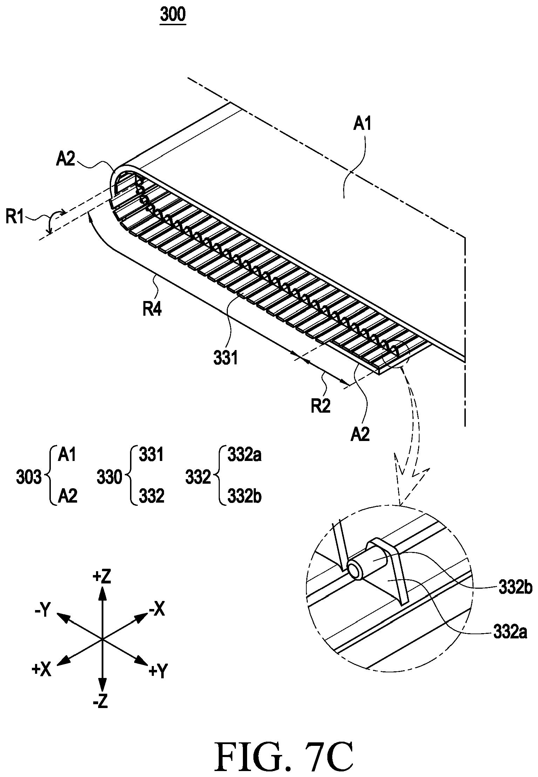

FIG. 7A is a view illustrating a second display area and a supporting structure according to various embodiments of the disclosure. FIG. 7B is a view illustrating a second display area and a supporting structure, as viewed from a direction opposite to that of FIG. 7A, according to various embodiments of the disclosure. FIG. 7C is a perspective view illustrating a display and a supporting structure according to various embodiments of the disclosure.

Referring to FIGS. 7A to 7C, an electronic device 300 (e.g., the electronic device 300 of FIGS. 3 to 6E) may include a second display area A2 and a supporting structure 330.

The configuration of the second display area A2 and the supporting structure 330 of FIGS. 7A to 7C may be identical in whole or part to the configuration of the second display area A2 and the supporting structure 330 of FIGS. 3 to 6E.

FIG. 7A illustrates a display (e.g., the display 303 of FIG. 3) in which the first display area A1 is omitted for convenience of description.

According to an embodiment, the second display area A2 may include a first surface (e.g., the surface shown in FIG. 7A) that is visually exposed to the user and a second surface (e.g., the surface where the supporting structure 330 is attached among the surfaces shown in FIG. 7C) facing in the opposite direction to the first surface. According to an embodiment, the supporting structure 330 may be attached or coupled to the second surface of the second display area A2.

According to the invention, the supporting structure 330 includes a plurality of bars 331. The plurality of bars 331 may be formed to extend in a straight line. The plurality of bars 331 includes a plurality of first bars R1 and R2 having a first length in a first direction (e.g., the X-axis direction of FIG. 7C) and a plurality of second bars R4 having a second length larger than the first length in the first direction (e.g., the X-axis direction of FIG. 7C).

According to an embodiment, each bar 331 may include a pair of insertion members 332 respectively disposed at two opposite ends of the bar 331. The insertion member 332 may include a first insertion member 332a protruding from at least a portion of the bar 331 and a second insertion member 332b protruding from at least a portion of the first insertion member 332a in the width direction (e.g., the X-axis direction of FIG. 7C) of the electronic device 300.

According to an embodiment, the second insertion member 332b may be configured to be inserted into a groove-shaped rail formed in a guide rail (e.g., the guide rail 370 of FIG. 3).

According to an embodiment, when the first display area A1 slides in the sliding direction (e.g., the Y-axis direction of FIG. 7C), the second insertion member 332b moves along the rail of the guide rail (e.g., the guide rail 370 of FIG. 3) so that the second display area A2 supported by the plurality of bars 331 may form a curved shape or flat shape.

According to an embodiment, the plurality of bars R1, R2, and R4 may be continuously disposed in parallel to each other.

According to an embodiment, the plurality of first bars R1 and R2 may include a plurality of 1-1th bars R1 and a plurality of 1-2th bars R2. According to an embodiment, the plurality of 1-1th bars R1 and the plurality of 1-2th bars R2 may have substantially the same length. According to an embodiment, the plurality of second bars R4 may be disposed between the plurality of 1-1th bars R1 and the plurality of 1-2th bars R2.

According to an embodiment, the plurality of 1-1th bars R1 may be components for supporting a portion of the second display area A2 connected to the first display area A1.

According to an embodiment, the plurality of 1-2th bars R2 may be components for supporting a portion of the second display area A2 that is farthest from the first display area A1 when the display 303 is spread out.

According to an embodiment, the plurality of second bars R4 may be components for supporting a portion of the second display area A2 that is not supported by the plurality of first bars R1 and R2. For example, the plurality of second bars R4 may be disposed between the plurality of 1-1th bars R1 and the plurality of 1-2th bars R2.

According to an embodiment, the plurality of bars R1, R2, and R4 may be arranged such that the respective longitudinal centers of the bars R1, R2, and R4 are aligned on a straight line. Accordingly, as the centers of the plurality of first bars R1 and R2 and the plurality of second bars R4 (e.g., the longitudinal centers in the X-axis direction of FIGS. 7A and 7B) are arranged on a straight line (e.g., a straight line parallel with the Y-axis direction of FIGS. 7A and 7B), the two opposite ends (e.g., ends in the +X direction and ends in the -X direction of FIGS. 7A and 7B) of the plurality of second bars R4 having a larger length (e.g., the length in the X-axis direction of FIGS. 7A and 7B) than the plurality of first bars R1 and R2 may be disposed to extend or be exposed more in the width direction (e.g., the X-axis direction of FIG. 7A) of the second display area A2 than the two opposite ends (e.g., ends in the +X direction and ends in the -X direction of FIGS. 7A and 7B) of the plurality of first bars R1 and R2. In an embodiment, the differences d1 in length or steps between two opposite ends of the plurality of second bars R4 and two opposite ends of the plurality of first bars R1 and R2 may be about 0.6mm to about 1.0mm at each of the two opposite ends. For example, the difference d1 in length or the step may be about 0.8mm.

According to an embodiment, the two opposite ends of the plurality of second bars R4 may have portions protruding beyond the two opposite ends of the plurality of first bars R1 and R2. In an embodiment, the length d1 of the protruding portion may be 0.6 mm to 1.0 mm. For example, the length d1 of the protruding portion may be 0.8 mm.

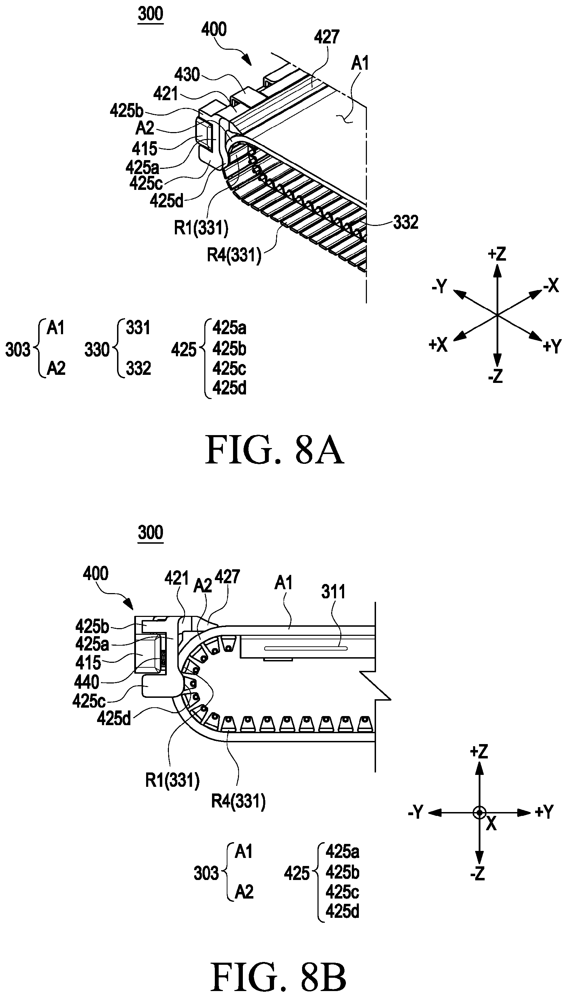

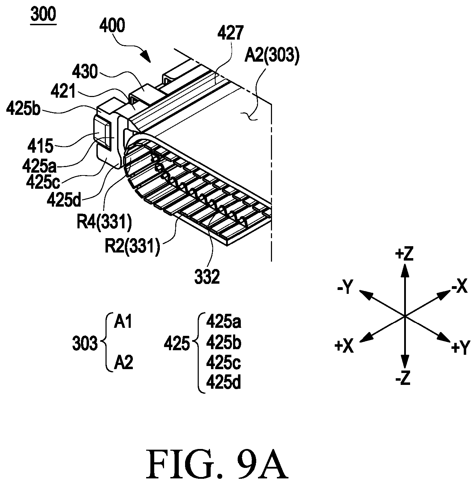

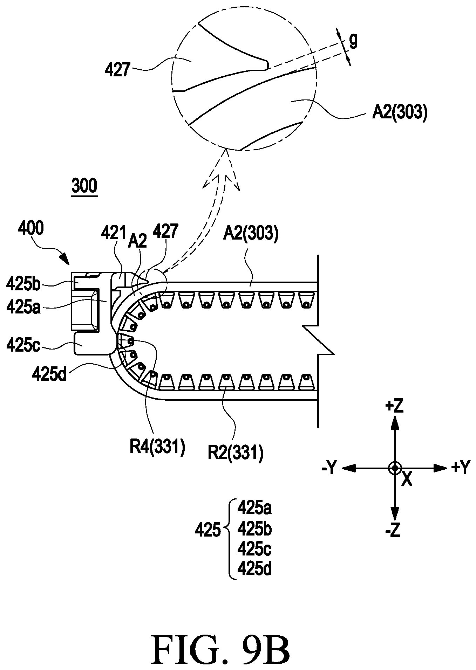

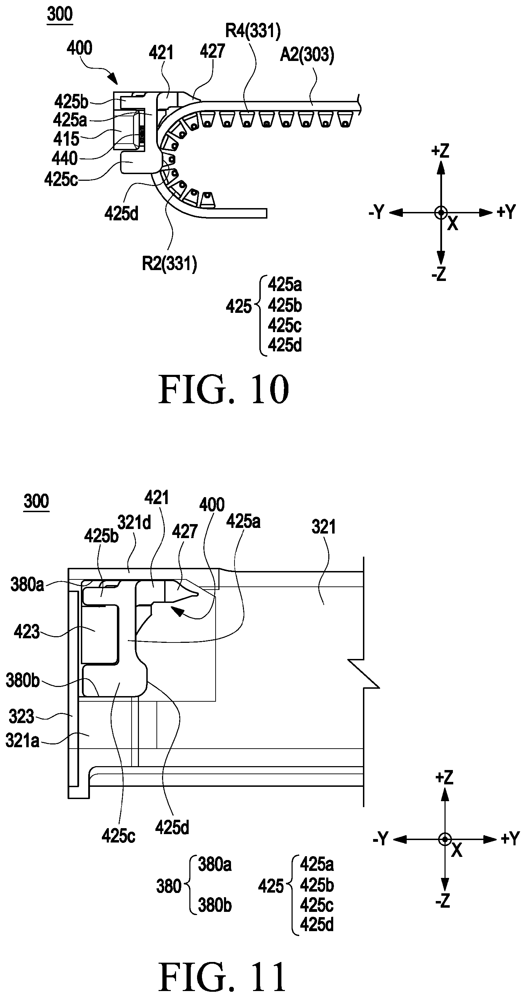

FIG. 8A is a perspective view illustrating a blocking member and a supporting structure according to various embodiments of the disclosure. FIG. 8B is a side view illustrating a blocking member and a supporting structure according to various embodiments of the disclosure. FIG. 9A is a perspective view illustrating a blocking member and a supporting structure according to various embodiments of the disclosure. FIG. 9B is a side view illustrating a blocking member and a supporting structure according to various embodiments of the disclosure. FIG. 10 is a side view illustrating a blocking member and a supporting structure according to various embodiments of the disclosure.

FIGS. 8A and 8B are views illustrating a blocking member and a supporting structure when the electronic device 300 is in a closed state (e.g., FIG. 2A). FIGS. 9A and 9B are views illustrating a blocking member and a supporting structure when the electronic device 300 changes from the closed state (e.g., FIG. 2A) to the opened state (e.g., FIG. 2B) or when the electronic device 300 changes from the opened state (e.g., FIG. 2B) to the closed state (e.g., FIG. 2A). FIG. 10 is a view illustrating a blocking member and a supporting structure when the electronic device 300 is in an opened state (e.g., FIG. 2B).

Referring to FIGS. 8A to 10, an electronic device 300 (e.g., the electronic device 300 of FIGS. 3 to 7C) may include a display 303, a supporting structure 330, and a blocking member 400.

The configuration of the display 303, the supporting structure 330, and the blocking member 400 of FIGS. 8A to 10 may be identical in whole or part to the configuration of the display 303, the supporting structure 330, and the blocking member 400 of FIGS. 3 to 7C.

FIGS. 8A and 8B illustrate an arrangement relationship between the blocking member 400 and the supporting structure 330 when the electronic device 300 is in a closed state (e.g., FIG. 2A).

Referring to FIGS. 8A and 8B, when the electronic device 300 is in a closed state (e.g., FIG. 2A), the second blocking portion 427 may come in tight contact with at least a portion of the second display area A2.

According to an embodiment, the base portion 410 may be inserted into the seating structure (e.g., the seating structure 380 of FIG. 5) of the second plate (e.g., the second plate 321 of FIG. 5) and be fixed to the second plate (e.g., the second plate 321 of FIG. 5).

According to an embodiment, the base portion 410 may have a fixed position with respect to the second plate (e.g., the second plate 321 of FIG. 5). According to an embodiment, the elastic portion 440 disposed between the fourth protrusion 415 of the base portion 410 and the second guide portion 425a may pressurize the second connecting portion 425a of the second guide portion 425 in the first sliding direction (e.g., the +Y direction of FIGS. 8A and 8B). According to an embodiment, the blocking portion 420 may be pressed by the elastic portion 440 to be slid in a direction away from the base portion 410 (e.g., the +Y direction or the first sliding direction in FIGS. 8A and 8B).

According to an embodiment, since the second upper guide portion 425b and the second lower guide portion 425c of the second guide portion 425 are brought in tight contact with the upper and lower ends of the fourth protrusion 415, the first blocking portion 421 and the second blocking portion 427 connected thereto may be slid in the first sliding direction (e.g., the +Y direction of FIGS. 8A to 8B) without being tilted.

According to an embodiment, when the electronic device 300 is in the closed state (e.g., FIG. 2A), at least one of the plurality of 1-1th bars R1 of the supporting structure 330 may be disposed to overlap the sixth protrusion 425d of the second guide portion 425 in the width direction of the electronic device 300 (e.g., the X-axis direction of FIGS. 8A and 8B). According to an embodiment, the plurality of 1-1th bars R1 may be disposed not to contact the sixth protrusion 425d of the second guide portion 425.

According to an embodiment, the second blocking portion 427 may be slid in the first sliding direction (e.g., the +Y direction of FIGS. 8A to 8B) to come in tight contact with at least a portion of the second display area A2. Accordingly, as described in connection with FIGS. 4A and 4B, the predetermined gap formed between the front surface (e.g., the front surface 321d of FIGS. 4A and 4B) of the second plate (e.g., the second plate 321 of FIGS. 4A and 4B) and the second display area A2 may be sealed by the second blocking portion 427.

According to an embodiment, as the second blocking portion 427 seals the gap when the electronic device 300 is in the closed state (e.g., FIG. 2A or 4A), it is possible to block influx of a foreign object from the outside to the inside of the electronic device 300 through the gap formed between the second plate (e.g., the second plate 321 of FIGS. 4A and 4B) and the second display area A2.

FIGS. 9A and 9B illustrate an arrangement relationship between a blocking member 400 and a supporting structure 330 when the electronic device 300 changes from the closed state (e.g., FIG. 2A) to the opened state (e.g., FIG. 2B) or when the electronic device 300 changes from the opened state (e.g., FIG. 2B) to the closed state (e.g., FIG. 2A). Hereinafter, for convenience of description, a case in which the electronic device 300 changes from a closed state to an opened state is described as an example, but a case in which the electronic device 300 changes from an opened state to a closed state should be understood in the same way.

Referring to FIGS. 9A and 9B, when the electronic device 300 changes from the closed state (e.g., FIG. 2A) to the opened state (e.g., FIG. 2B), the second blocking portion 427 may be spaced apart from at least a portion of the second display area A2.

According to an embodiment, when the second display area A2, along with the first display area A1, is slid in the first sliding direction (e.g., the +Y direction of FIGS. 9A and 9B), at least one of the plurality of second bars R4 supporting the rolled portion of the second display area A2 may pressurize the sixth protrusion 425d of the second guide portion 425.

According to the invention, the plurality of second bars R4 are longer than the plurality of first bars R1 and R2, so that at least one of the plurality of second bars R4 pressurizes the sixth protrusion 425d by contacting the sixth protrusion 425d.

According to an embodiment, as the sixth protrusion 425d is pressurized in the second sliding direction (e.g., the -Y direction of FIG. 9A and 9B), the blocking portion 420 including the first blocking portion 421 and the second blocking portion 427 connected thereto may be slid in the direction (e.g., the - Y direction or second sliding direction of FIGS. 9A and 9B) closer to the base portion 410.

According to an embodiment, as the first blocking portion 421 is slid in the second sliding direction, the elastic portion 440 disposed between the second guide portion 425 and the fourth protrusion 415 may be compressed.

According to an embodiment, as the second blocking portion 427 is slid in the second sliding direction, the second blocking portion 427 may be spaced apart from at least a portion of the second display area A2.

According to an embodiment, the second blocking portion 427 may be spaced apart from the second display area A2 to form a predetermined gap g. The spacing between the second blocking portion 427 and the second display area A2 or the thickness of the gap g may be 0.05mm to 0.15mm. In an embodiment, the spacing may be 0.1 mm.

For example, when the second display area A2 is not spaced apart from the second blocking portion 427 when sliding, friction may occur against the second display area A2 due to the second blocking portion 427. According to an embodiment, as the second blocking portion 427 is spaced apart from at least a portion of the second display area A2, no friction may occur against the second display area A2 when the second display area A2 slides in the first sliding direction (e.g., the +Y direction of FIGS. 9A and 9B).

According to various embodiments, as the spacing between the second blocking portion 427 and the second display area A2 is relatively small (e.g., 0.1mm), it is possible to block influx of an external foreign object into the electronic device 300 during the time required when the electronic device 300 is opened or closed.

FIG. 10 illustrates an arrangement relationship between the blocking member 400 and the supporting structure 330 when the electronic device 300 is in an opened state (e.g., FIG. 2B).

Referring to FIG. 10, when the electronic device 300 is in an opened state (e.g., FIG. 2B), the second blocking portion 427 may come in tight contact with at least a portion of the second display area A2.

According to an embodiment, the elastic portion 440 disposed between the fourth protrusion 415 of the base portion 410 and the second guide portion 425a may pressurize the second connecting portion 425a of the second guide portion 425 in the first sliding direction (e.g., the +Y direction of FIGS. 8A and 8B). According to an embodiment, the blocking portion 420 may be pressed by the elastic portion 440 to be slid in a direction away from the base portion 410 (e.g., the +Y direction or the first sliding direction in FIGS. 8A and 8B).

According to an embodiment, since the second upper guide portion 425b and the second lower guide portion 425c of the second guide portion 425 are brought in tight contact with the upper and lower ends of the fourth protrusion 415, the first blocking portion 421 and the second blocking portion 427 connected thereto may be slid in the first sliding direction (e.g., the +Y direction of FIGS. 8A to 8B) without being tilted.

According to an embodiment, when the electronic device 300 is in the opened state (e.g., FIG. 2B), at least one of the plurality of 1-2th bars R2 of the supporting structure 330 may be disposed to overlap the sixth protrusion 425d of the second guide portion 425 in the width direction of the electronic device 300 (e.g., the X-axis direction of FIG. 10). According to an embodiment, the plurality of 1-2th bars R2 may be disposed not to contact the sixth protrusion 425d of the second guide portion 425.

According to an embodiment, the second blocking portion 427 may be slid in the first sliding direction (e.g., the +Y direction of FIG. 10) to come in tight contact with at least a portion of the second display area A2. Accordingly, as described in connection with FIGS. 4A and 4B, the predetermined gap formed between the front surface (e.g., the front surface 321d of FIGS. 4A and 4B) of the second plate (e.g., the second plate 321 of FIGS. 4A and 4B) and the second display area A2 may be sealed by the second blocking portion 427.

According to an embodiment, as the second blocking portion 427 seals the gap when the electronic device 300 is in the opened state (e.g., FIG. 2B or 4B), it is possible to block influx of a foreign object from the outside to the inside of the electronic device 300 through the gap formed between the second plate (e.g., the second plate 321 of FIGS. 4A and 4B) and the second display area A2.

Referring to FIGS. 8A to 10 as an example, the second blocking portion 427 of the blocking member 400 may include a silicone member or a rubber member which is a soft material. According to an embodiment, even when the second blocking portion 427 is in tight contact with the second display area A2, a scratch may be prevented from being formed in the second display area A2. According to another embodiment, the second blocking portion 427 may include a film member formed of a soft material, a polymer member, or a mohair member and may further include various means that are elastically deformed when tightly contacting the second display area A2 and are elastically restored when spaced apart from the second display area A2.

According to an embodiment, as the second blocking portion 427 of the blocking member 400 comes in tight contact with the second display area A2 when the electronic device 300 is in the fully opened state or closed state, it is possible to block influx of an external foreign object into the electronic device 300.

According to an embodiment, as the second blocking portion 427 of the blocking member 400 is spaced apart from at least a portion of the second display area A2 by a predetermined gap g when the electronic device 300 changes from the closed state to the opened state or from the opened state to the closed state, no friction may occur against the surface of the second display area A2.

According to an embodiment, the blocking member 400 may be coupled so that the blocking portion 420 and the base portion 410 have a pivot structure. For example, the blocking portion 420 may be rotated about at least a portion of the base portion 410 in one direction (e.g., the counterclockwise direction of FIG. 8B) with respect to the axis direction (e.g., the X-axis direction of FIG. 8B) of the base portion 410 or in the other direction (e.g., the clockwise direction of FIG. 8B) which is the opposite direction to the one direction. According to an embodiment, when the blocking portion 420 is rotated in the one direction with respect to the axis direction, the second blocking portion 427 of the blocking portion 420 may be spaced apart from at least a portion of the display 303 and, when the blocking portion 420 is rotated in the other direction with respect to the axis direction, the second blocking portion 427 of the blocking portion 420 may be brought in tight contact with at least a portion of the display 303. According to an embodiment, the plurality of first bars R1 and R2 have a length (e.g., the length in the X-axis direction of FIG. 8B) larger than the plurality of second bars R4 and, when the plurality of first bars R1 and R4 pressurize at least a portion (e.g., the sixth protrusion 425d) of the second guide portion 425, the blocking portion 420 may be rotated in the other direction about the base portion 410. To that end, the second guide portion 425 may have a groove or recess depressed to form a predetermined gap between it and the fourth protrusion 415 in at least a portion (e.g., the second upper guide portion 425b or the second lower guide portion 425c). The groove or recess formed in at least a portion (e.g., the second upper guide portion 425b or the second lower guide portion 425c) of the second guide portion 425 may provide an extra space to allow the blocking portion 420 to rotate about the base portion 410. For example, if no groove or recess is formed, the blocking portion 420 may slide only in the linear direction (e.g., the Y-axis direction of FIG. 8B) about the base portion 410. Accordingly, the predetermined gap formed between it and the fourth protrusion 415 through the groove or recess may provide an extra space to allow for rotation about the base portion 410. When contacted by the plurality of first bars R1 and R2, the blocking portion 420 may be rotated in the other direction (e.g., the clockwise direction of FIG. 8B) about the base portion 410, and the elastic portion 440 may be compressed by the second blocking portion 427. Accordingly, the second blocking portion 427 may come in tight contact with at least a portion of the display 303. Further, the plurality of second bars R4 may not contact at least a portion of the second guide portion 425, and at least one of the plurality of second bars R4 may be disposed to overlap at least a portion (e.g., the sixth protrusion 425d) of the second guide portion 425 in the width direction (e.g., the X-axis direction of FIG. 8B) of the electronic device 300. According to an embodiment, since the second guide portion 425 is not pressurized by the plurality of second bars R4, at least a portion of the second blocking portion 427 may be pressurized by the elastic restoring force of the elastic portion 440. Accordingly, the blocking portion 420 may be rotated in the one direction (e.g., the clockwise direction of FIG. 8B), and the second blocking portion 427 may be spaced apart from at least a portion of the display 303.

FIG. 11 is a cross-sectional view illustrating a coupling relationship between a second plate and a blocking member according to various embodiments of the disclosure.

Referring to FIG. 11, an electronic device 300 (e.g., the electronic device 300 of FIGS. 3 to 10) may include a second plate 321 and a blocking member 400.

The configuration of the second plate 321 and/or the blocking member 400 of FIG. 11 may be identical in whole or part to the configuration of the second plate 321 and/or the blocking member 400 of FIGS. 3 to 10.

According to an embodiment, the 2-1th sidewall 321a of the second plate 321 and/or the blocking member 400 may be covered by a deco member 323 (e.g., the deco member 323 of FIG. 5).

According to an embodiment, the 2-1th sidewall 321a of the second plate 321 may include a seating structure 380 (e.g., the seating structure 380 of FIG. 8). According to an embodiment, the blocking member 400 may be inserted into the seating structure 380.

According to an embodiment, the seating structure 380 may include a first surface 380a constituting an upper surface (e.g., the surface facing in the +Z direction of FIG. 11) of the second opening (e.g., the second opening 383 of FIG. 5) and a second surface 380b constituting a lower surface (e.g., the surface facing in the -Z direction of FIG. 11) of the second opening.

According to an embodiment, the first surface 380a may be a surface formed by the front surface 321d, and the second surface 380b may be a surface formed as a portion where the second opening of the 2-1th sidewall 321a is not formed.

According to an embodiment, the first surface 380a may contact the first blocking portion 421 of the blocking member 400. According to an embodiment, the second surface 380b may contact the second lower guide portion 425c of the blocking member 400.

According to an embodiment, as the blocking member 400 is constrained by the first surface 380a and the second surface 380b of the second plate 321, the blocking portion 420 of the blocking member 400 may be limited from tilting.

According to an embodiment, the first blocking portion 421 may be configured so that at least a portion (e.g., the portion facing in the +Z direction of FIG. 11) of the first blocking portion 421 tightly contacts at least a portion (e.g., the first surface 380a of the seating structure 380) of the second housing (e.g., the second plate 321 of FIG. 11), and another portion (e.g., the portion facing in the -Z direction of FIG. 11) different from the at least one portion of the first blocking portion 421 tightly contacts another portion (e.g., the second surface 380b of the seating structure 380) different from the at least one portion of the second housing (e.g., the second plate 321 of FIG. 11).

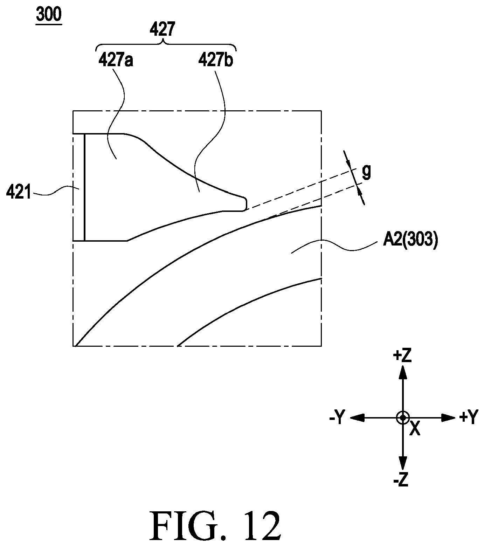

FIG. 12 is a view illustrating a second blocking portion and a second display area according to various embodiments of the disclosure.

Referring to FIG. 12, an electronic device 300 (e.g., the electronic device 300 of FIGS. 3 to 11) may include a blocking member (e.g., the blocking member 400 of FIG. 9B) including a first blocking portion 421 and a second blocking portion 427 coupled with the first blocking portion 421.

The configuration of the first blocking portion 421 and the second blocking portion 427 of FIG. 12 may be identical in whole or part to the configuration of the first blocking portion 421 and the second blocking portion 427 of FIGS. 5 to 11.

According to various embodiments, the second blocking portion 427 may be spaced apart from at least a portion of the second display area A2 of the display 303 by a predetermined gap g when the electronic device 300 changes from the closed state (e.g., FIG. 2A) to the opened state (e.g., FIG. 2B) or when the electronic device 300 changes from the opened state (e.g., FIG. 2B) to the closed state (e.g., FIG. 2A).

According to an embodiment, the second blocking portion 427 may include a first blocking section 427a connected with the first blocking portion 421 and a second blocking section 427b extending from the first blocking section 427a. According to an embodiment, the second blocking section 427b of the second blocking portion 427 may be a portion that is brought in tight contact with or spaced apart from the second display area A2 of the display 303.

According to an embodiment, the second blocking portion 427 may have a shape which gradually reduces in cross-sectional area (e.g., the cross-sectional area on the Z-X plane formed by a combination of the Z axis and X axis of FIG. 12) from the second blocking section 427b to the second blocking section 427b. According to an embodiment, the second blocking portion 427 may have a scrapper shape that gradually thins from the first blocking section 427a to the second blocking section 427b.

According to an embodiment, an end (e.g., the end facing in the +Y direction of FIG. 12) of the second blocking section 427b of the second blocking portion 427 may come in tight point contact with or tightly contact, in a tiny area, at least a portion of the second display area A2.

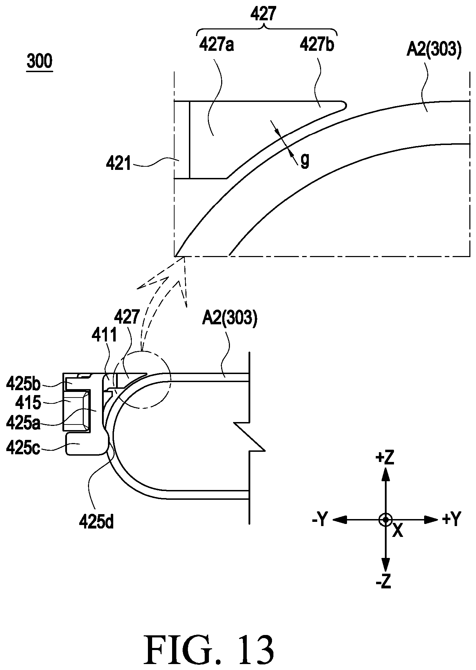

FIG. 13 is a view illustrating a second blocking portion and a second display area according to various embodiments of the disclosure.

Referring to FIG. 13, an electronic device 300 (e.g., the electronic device 300 of FIGS. 3 to 11) may include a blocking member (e.g., the blocking member 400 of FIG. 9B) including a first blocking portion 421 and a second blocking portion 427 coupled with the first blocking portion 421.

The configuration of the first blocking portion 421 and the second blocking portion 427 of FIG. 13 may be identical in whole or part to the configuration of the first blocking portion 421 and the second blocking portion 427 of FIGS. 5 to 11.

According to various embodiments, the second blocking portion 427 may be spaced apart from at least a portion of the second display area A2 of the display 303 by a predetermined gap g when the electronic device 300 changes from the closed state (e.g., FIG. 2A) to the opened state (e.g., FIG. 2B) or when the electronic device 300 changes from the opened state (e.g., FIG. 2B) to the closed state (e.g., FIG. 2A).

According to an embodiment, the second blocking portion 427 may include a first blocking section 427a connected with the first blocking portion 421 and a second blocking section 427b extending from the first blocking section 427a. According to an embodiment, the second blocking section 427b of the second blocking portion 427 may be a portion that is brought in tight contact with or spaced apart from the second display area A2 of the display 303.

According to an embodiment, the second blocking portion 427 may have a shape which gradually reduces in cross-sectional area (e.g., the cross-sectional area on the Z-X plane formed by a combination of the Z axis and X axis of FIG. 13) from the second blocking section 427b to the second blocking section 427b.

According to an embodiment, the upper end (e.g., the end facing in the +Z direction in FIG. 13) of the second blocking portion 427 may extend in substantially parallel to the sliding direction (e.g., the Y-axis direction of FIG. 13) of the second blocking portion 427. According to an embodiment, the upper end of the second blocking portion 427 may be subjected to various design changes depending on the structure of the second plate (e.g., the second plate 321 of FIG. 5) or the blocking member (e.g., the blocking member 400 of FIG. 5).

According to an embodiment, the lower end (e.g., the end facing in the -Z direction of FIG. 13) of the second blocking section 427b may be formed to have a curvature substantially corresponding to the rolled portion or curved portion of the second display area A2. According to an embodiment, the lower end of the second blocking section 427b may come in surface contact with at least a portion of the second display area A2.

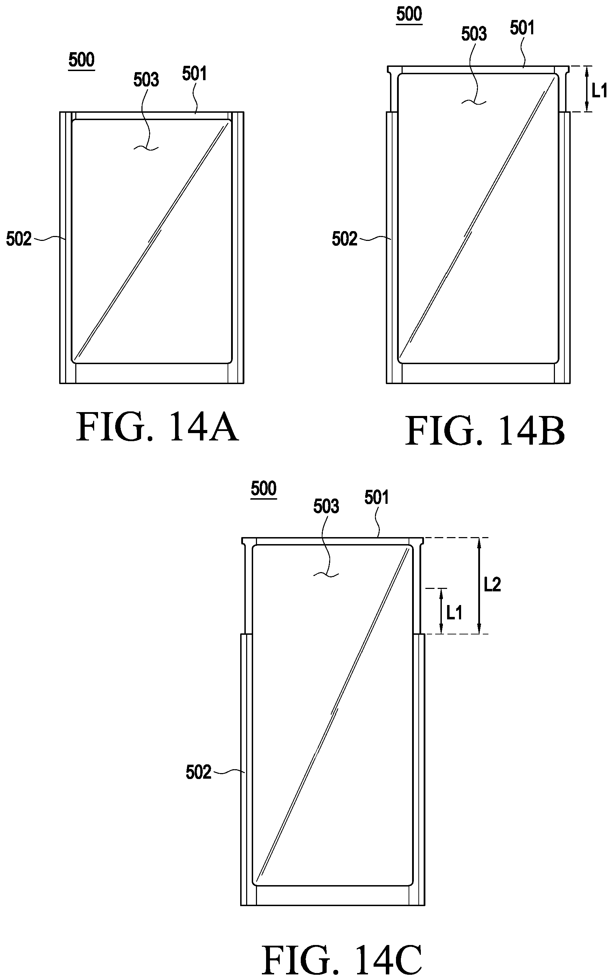

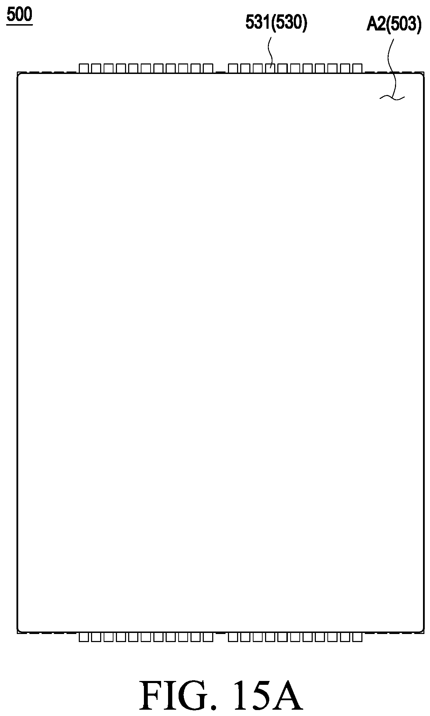

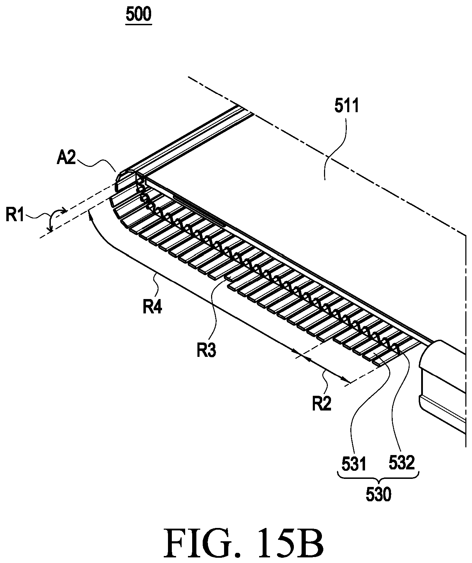

FIG. 14A is a view illustrating a closed state of an electronic device according to various embodiments of the disclosure. FIG. 14B is a view illustrating an intermediate state of an electronic device according to various embodiments of the disclosure. FIG. 14C is a view illustrating an opened state of an electronic device according to various embodiments of the disclosure. FIG. 15A is a view illustrating a second display area and a supporting structure according to various embodiments of the disclosure. FIG. 15B is a view illustrating a second display area and a supporting structure, as viewed from a direction opposite to that of FIG. 15A, according to various embodiments of the disclosure.

Referring to FIGS. 14A to 15B, an electronic device 500 (e.g., the electronic device 300 of FIGS. 3 to 13) may include a first housing 501 (e.g., the first housing 301 of FIGS. 3 to 13), a second housing 502 (e.g., the second housing 302 of FIGS. 3 to 13), a display 503 (e.g., the display 503 of FIGS. 3 to 13), and/or a supporting structure 530 (e.g., the supporting structure 530 of FIGS. 3 to 13).

According to various embodiments, the second housing 502 may be a component for receiving at least a portion of the first housing 501 and guiding the slide of the first housing 501.

According to various embodiments, the display 503 may include a first display area A1 (e.g., the first display area A1 of FIGS. 3 to 13) and a second display area A2 (e.g., the second display area A2 of FIGS. 3 to 13) extending from the first display area A1.

According to various embodiments, the supporting structure 530 (e.g., the supporting structure 330 of FIGS. 3 to 13) may include a plurality of bars R1, R2, R3, and R4. According to an embodiment, the plurality of bars R1, R2, R3, and R4 may include a plurality of first bars R1, R2, and R3 and a plurality of second bars R4. According to an embodiment, the plurality of first bars R1, R2, and R3 may include a plurality of 1-1th bars R1, a plurality of 1-2th bars R2, and at least one third bar R3. According to an embodiment, the at least one 1-3th bar R3 may be disposed between a pair of adjacent second bars R4 among the plurality of second bars R4.

According to an embodiment, the area of the display 503 visually exposed may differ in each of the closed state (e.g., FIG. 14A or 2A), the opened state (e.g., FIG. 14C or 2B), or the intermediate state (e.g., FIG. 14B) of the electronic device 500.

According to an embodiment, as at least a portion of the second blocking portion (e.g., the second blocking portion 427 of FIGS. 5 to 13) of the blocking member (e.g., the blocking member 400 of FIGS. 5 to 13) tightly contacts at least a portion of the second display area A2 when the electronic device 500 is in the closed state (e.g., FIG. 14A), it is possible to block influx of an external foreign object into the electronic device 500. According to an embodiment, as the elastic portion (e.g., the elastic portion 440 of FIGS. 5 to 13) of the blocking member (e.g., the blocking member 400 of FIGS. 5 to 13) pressurizes the blocking portion (e.g., the blocking portion 420 of FIGS. 5 to 13) when the electronic device 500 is in the closed state, the second blocking portion may tightly contact at least a portion of the second display area. According to an embodiment, when the electronic device 500 is in the closed state, at least one of the plurality of 1-1th bars R1 may be disposed to overlap the sixth protrusion (e.g., the sixth protrusion 425d of FIGS. 5 to 13) of the blocking member (e.g., the blocking member 400 of FIGS. 5 to 13) in the width direction (e.g., the X-axis direction of FIGS. 3 to 13) of the electronic device 500.

According to an embodiment, when the electronic device 500 changes from the closed state (e.g., FIG. 14A or 2A) to the intermediate state (e.g., FIG. 14B), at least a portion of the second blocking portion (e.g., the second blocking portion 427 of FIGS. 5 to 13) of the blocking member (e.g., the blocking member 400 of FIGS. 5 to 13) may be spaced apart from at least a portion of the second display area A2. According to an embodiment, as at least one of the plurality of second bars R4 pressurizes the sixth protrusion (e.g., the sixth protrusion 425d of FIGS. 5 to 13) of the blocking member (e.g., the blocking member 400 of FIGS. 5 to 13) when the electronic device 500 changes from the closed state to the intermediate state, the second blocking portion may be spaced apart from at least a portion of the second display area, and the elastic portion (e.g., the elastic portion 440 of FIGS. 5 to 13) may be compressed by the blocking portion (e.g., the blocking portion 420 of FIGS. 5 to 13).

According to an embodiment, as at least a portion of the second blocking portion (e.g., the second blocking portion 427 of FIGS. 5 to 13) of the blocking member (e.g., the blocking member 400 of FIGS. 5 to 13) tightly contacts at least a portion of the second display area A2 when the electronic device 500 is in the intermediate state (e.g., FIG. 14B), it is possible to block influx of an external foreign object into the electronic device 500. According to an embodiment, as the elastic portion (e.g., the elastic portion 440 of FIGS. 5 to 13) of the blocking member (e.g., the blocking member 400 of FIGS. 5 to 13) pressurizes the blocking portion (e.g., the blocking portion 420 of FIGS. 5 to 13) when the electronic device 500 is in the intermediate state, the second blocking portion may tightly contact at least a portion of the second display area. According to an embodiment, when the electronic device 500 is in the intermediate state, at least one 1-3th bar R3 may be disposed to overlap the sixth protrusion (e.g., the sixth protrusion 425d of FIGS. 5 to 13) of the blocking member (e.g., the blocking member 400 of FIGS. 5 to 13) in the width direction (e.g., the X-axis direction of FIGS. 3 to 13) of the electronic device 500. According to an embodiment, the area in which the display 503 of the electronic device 500 is visually exposed when the electronic device 500 is in the intermediate state (e.g., FIG. 14B) may be larger than the area in which the display 503 of the electronic device 500 is visually exposed in the closed state (e.g., FIG. 14A). According to an embodiment, the length of the display visually exposed when the electronic device is in the intermediate state may be a first length L1 larger than the length of the display visually exposed when the electronic device is in the closed state.

According to an embodiment, when the electronic device 500 changes from the intermediate state (e.g., FIG. 14B) to the opened state (e.g., FIG. 14C or 2B), at least a portion of the second blocking portion (e.g., the second blocking portion 427 of FIGS. 5 to 13) of the blocking member (e.g., the blocking member 400 of FIGS. 5 to 13) may be spaced apart from at least a portion of the second display area A2. According to an embodiment, as at least one of the plurality of second bars R4 pressurizes the sixth protrusion (e.g., the sixth protrusion 425d of FIGS. 5 to 13) of the blocking member (e.g., the blocking member 400 of FIGS. 5 to 13) when the electronic device 500 changes from the intermediate state to the opened state, the second blocking portion may be spaced apart from at least a portion of the second display area, and the elastic portion (e.g., the elastic portion 440 of FIGS. 5 to 13) may be compressed by the blocking portion (e.g., the blocking portion 420 of FIGS. 5 to 13).

According to an embodiment, as at least a portion of the second blocking portion (e.g., the second blocking portion 427 of FIGS. 5 to 13) of the blocking member (e.g., the blocking member 400 of FIGS. 5 to 13) tightly contacts at least a portion of the second display area A2 when the electronic device 500 is in the opened state (e.g., FIG. 14C), it is possible to block influx of an external foreign object into the electronic device 500. According to an embodiment, as the elastic portion (e.g., the elastic portion 440 of FIGS. 5 to 13) of the blocking member (e.g., the blocking member 400 of FIGS. 5 to 13) pressurizes the blocking portion (e.g., the blocking portion 420 of FIGS. 5 to 13) when the electronic device 500 is in the opened state, the second blocking portion may tightly contact at least a portion of the second display area. According to an embodiment, when the electronic device 500 is in the opened state, at least one of the plurality of 1-2th bars R2 may be disposed to overlap the sixth protrusion (e.g., the sixth protrusion 425d of FIGS. 5 to 13) of the blocking member (e.g., the blocking member 400 of FIGS. 5 to 13) in the width direction (e.g., the X-axis direction of FIGS. 3 to 13) of the electronic device 500. According to an embodiment, the area in which the display 503 of the electronic device 500 is visually exposed when the electronic device 500 is in the opened state (e.g., FIG. 14C) may be larger than the area in which the display 503 of the electronic device 500 is visually exposed in the closed state (e.g., FIG. 14A). According to an embodiment, the length of the display visually exposed when the electronic device is in the opened state may be a second length L2 larger than the length of the display visually exposed when the electronic device is in the closed state. According to an embodiment, the length of the display visually exposed when the electronic device is in the opened state may be larger than the length of the display visually exposed when the electronic device is in the intermediate state.

According to various embodiments of the disclosure, an electronic device (e.g., the electronic device 101 of FIG. 1, the electronic device 200 of FIGS. 2A to 2C, or the electronic device 300 of FIGS. 3 to 5) may comprise a housing (e.g., the housings 301 and 302 of FIGS. 3 to 5) including a first housing (e.g., the first housing 301 or first plate 311 of FIGS. 3 to 5) and a second housing (e.g., the second housing 302 or second plate 321 of FIGS. 3 to 5) for guiding a slide of the first housing; a display (e.g., the display 303 of FIGS. 3 to 4B) including a first display area (e.g., the first display area A1 of FIGS. 3 to 4B) disposed on the first housing and a second display area (e.g., the second display area A2 of FIGS. 3 to 4B) extending from the first display area and configured to move at least a portion of the second display area based on the slide of the first housing; a supporting structure (e.g., the supporting structure 330 of FIG. 3 or the supporting structure 330 of FIGS. 7A and 7B) configured to support at least a portion of the first display area or at least a portion of the second display area and including a plurality of bars (e.g., the plurality of bars R1, R2, and R4 of FIGS. 7A and 7B); and a blocking member (e.g., the blocking member 400 of FIGS. 5 to 6A) for blocking influx of an external foreign object through a gap between the housing and the display. When the first housing slides, at least one of the plurality of bars may be configured to pressurize and push out the blocking member to space the display and the blocking member apart from each other.

According to various embodiments, the blocking member may include a base portion (e.g., the base portion 410 of FIGS. 5 to 6E) including at least a portion coupled to the housing; a blocking portion (e.g., the blocking portion 420 of FIGS. 5 to 6E) slidably coupled to the base portion; and an elastic portion (e.g., the elastic portion 440 of FIGS. 5 to 6E) disposed between the base portion and the blocking portion. The blocking portion may be configured to, when the housing is in a closed state or an opened state, be pressurized by the elastic portion to slide away from the base portion to allow at least a portion of the blocking portion to tightly contact the display, and when the housing changes from the closed state to the opened state or when the housing changes from the opened state to the closed state, be pressurized by from at least one of the plurality of bars to slide toward the base portion to allow the at least a portion of the blocking portion to be spaced apart from the display.

According to various embodiments, the blocking portion may include a first blocking portion (e.g., the first blocking portion 421 of FIGS. 5A to 6E) including at least a portion slidably coupled to the base portion and configured to be pressurized from the elastic portion or at least one of the plurality of bars; and a second blocking portion (e.g., the second blocking portion 427 of FIGS. 5A to 6E) coupled to the first blocking portion and configured to allow at least a portion of the second blocking portion to tightly contact the display or to be spaced apart from the display. The second blocking portion may include at least one of a rubber material or a silicone material.

According to various embodiments, the second blocking portion may be shaped to gradually reduce in cross-sectional area from a portion connected with the first blocking portion to a portion configured to tightly contact or be spaced apart from the display.

According to various embodiments, the blocking member may further include a cover portion (e.g., the cover portion 430 of FIGS. 5A to 6E) configured so that at least a portion of the cover portion is coupled to the base portion, and another portion other than the at least the portion of the cover portion is stuck to at least a portion of the blocking portion and configured to prevent the blocking portion from escaping off the base portion when the blocking portion approaches the display.

According to various embodiments, the blocking portion may include a fixing groove (e.g., the first recess 413a of FIGS. 5 to 6E) depressed in at least a portion. The cover portion may include a fixing portion (e.g., the fixing portion 431 of FIGS. 5 to 6E) fixed to the base portion, an extension (e.g., the extension 432 of FIGS. 5 to 6E) extending from the fixing portion to the blocking portion, and a bending portion (e.g., the bending portion 433 of FIGS. 5 to 6E) bent from the extension and inserted to the fixing groove.

According to various embodiments, the second housing may include a first sidewall (e.g., the 2-1th sidewall 321a of FIG. 50 including a seating structure (e.g., the seating structure 380 of FIG. 5). The blocking member may be disposed on the seating structure.

According to various embodiments, the electronic device may further comprise a deco member (e.g., the deco member 323 of FIG. 5) coupled to the first sidewall of the second housing and configured to cover the blocking member.

According to an embodiment, at least a portion (e.g., the portion facing in the +Z direction of FIG. 11) of the first blocking portion 421 may configure to tightly contact at least a portion (e.g., the first surface 380a of the seating structure 380) of the second housing (e.g., the second plate 321 of FIG. 11), and another portion (e.g., the portion facing in the -Z direction of FIG. 11) different from the at least the portion of the first blocking portion 421 may configure to tightly contact another portion (e.g., the second surface 380b of the seating structure 380) different from the at least the portion of the second housing (e.g., the second plate 321 of FIG. 11).

According to various embodiments, when the at least the portion of the blocking portion is spaced apart from the display, the spacing distance between the at least a portion of the blocking portion and the display may be 0.05mm to 0.15mm, preferably, 0.06mm to 0.14mm, and more preferably, 0.08mm to 0.12mm.

According to the invention, the plurality of bars includes a plurality of first bars (e.g., the plurality of first bars R1 and R2 of FIGS. 7A and 7B) having a first length in a first direction; and a plurality of second bars (e.g., the plurality of second bars R4 of FIGS. 7A and 7B) having a second length larger than the first length in the first direction.

According to various embodiments, at least one of the plurality of first bars may be disposed to overlap a partial area of the blocking portion in the first direction when the housing is in the closed state or the opened state, and at least one of the plurality of second bars may be configured to pressurize the partial area when the housing changes from the closed state to the opened state or when the housing changes from the opened state to the closed state.

According to various embodiments, the elastic portion may be configured to, when the housing is in the closed state or the opened state, pressurize the blocking portion to slide the blocking portion to bring the at least a portion of the blocking portion in tight contact with the display, and be pressurized and compressed by the blocking portion when the housing changes from the closed state to the opened state or when the housing changes from the opened state to the closed state.

According to various embodiments, the plurality of second bars may be continuously arranged. At least some (e.g., the plurality of 1-1th bars R1 of FIGS. 7A and 7B) of the plurality of first bars may be disposed on one side of the plurality of second bars. Others (e.g., the plurality of 1-2th bars R2 of FIGS. 7A and 7B) of the plurality of first bars may be disposed on another side of the plurality of second bars.

According to various embodiments, at least one (e.g., at least one 1-3th bar R3 of FIGS. 15A and 15B) of the plurality of first bars (e.g., the plurality of first bars R1, R2, and R3 of FIGS. 15A and 15B) may be disposed between a pair of adjacent second bars among the plurality of second bars.

According to various embodiments of the disclosure, an electronic device (e.g., the electronic device 101 of FIG. 1, the electronic device 200 of FIGS. 2A to 2C, or the electronic device 300 of FIGS. 3 to 5) may comprise a housing (e.g., the housings 301 and 302 of FIGS. 3 to 5) including a first housing (e.g., the first housing 301 or first plate 311 of FIGS. 3 to 5) and a second housing (e.g., the second housing 302 or second plate 321 of FIGS. 3 to 5) for guiding a slide of the first housing; a display (e.g., the display 303 of FIGS. 3 to 4B) including a first display area (e.g., the first display area A1 of FIGS. 3 to 4B) disposed on the first housing and a second display area (e.g., the second display area A2 of FIGS. 3 to 4B) extending from the first display area and configured to move at least a portion of the second display area based on the slide of the first housing; a supporting structure (e.g., the supporting structure 330 of FIG. 3 or the supporting structure 330 of FIGS. 7A and 7B) configured to support at least a portion of the first display area or at least a portion of the second display area and including a plurality of bars (e.g., the plurality of bars R1, R2, and R4 of FIGS. 7A and 7B); and a blocking member (e.g., the blocking member 400 of FIGS. 5 to 6A) disposed in the housing. The blocking member may include a base portion (e.g., the base portion 410 of FIGS. 5 to 6E) including at least a portion coupled to the housing; a blocking portion (e.g., the blocking portion 420 of FIGS. 5 to 6E) slidably coupled to the base portion; and an elastic portion (e.g., the elastic portion 440 of FIGS. 5 to 6E) disposed between the base portion and the blocking portion.

According to various embodiments, the blocking portion may include a first blocking portion (e.g., the first blocking portion 421 of FIGS. 5A to 6E) including at least a portion slidably coupled to the base portion and configured to be pressurized from the elastic portion or at least one of the plurality of bars; and a second blocking portion (e.g., the second blocking portion 427 of FIGS. 5A to 6E) coupled to the first blocking portion and configured to allow at least a portion of the second blocking portion to tightly contact the display or to be spaced apart from the display.

According to various embodiments, the first blocking portion and the second blocking portion may be integrally formed with each other.

According to various embodiments, the supporting structure may be configured to, when the housing is in the closed state or the opened state, be spaced apart from the blocking portion, and when the housing changes from the closed state to the opened state or when the housing changes from the opened state to the closed state, pressurize at least a portion of the blocking portion.

According to various embodiments of the disclosure, an electronic device (e.g., the electronic device 101 of FIG. 1, the electronic device 200 of FIGS. 2A to 2C, or the electronic device 300 of FIGS. 3 to 5) may comprise a housing (e.g., the housings 301 and 302 of FIGS. 3 to 5) including a first housing (e.g., the first housing 301 or the first plate 311of FIGS. 3 to 5) and a second housing (e.g., the second housing 302 or the second plate 321 of FIGS. 3 to 5) for guiding a slide of the first housing; a display (e.g., the display 303 of FIGS. 3 to 4B) including a first display area (e.g., the first display area A1 of FIGS. 3 to 4B) disposed on the first housing and a second display area (e.g., the second display area A2 of FIGS. 3 to 4B) extending from the first display area and configured to move at least a portion of the second display area based on the slide of the first housing; a supporting structure (e.g., the supporting structure 330 of FIG. 3 or the supporting structure 330 of FIGS. 7A and 7B) configured to support at least a portion of the first display area or at least a portion of the second display area and including a plurality of bars (e.g., the plurality of bars R1, R2, and R3 of FIGS. 7A and 7B); and a blocking member (e.g., the blocking member 400 of FIGS. 5 to 6A) disposed in the housing. The blocking member may include a base portion (e.g., the base portion 410 of FIGS. 5 to 6E) including at least a portion disposed on a seating structure (e.g., the seating structure 380 of FIG. 5) formed in the second housing; a blocking portion (e.g., the blocking portion 420 of FIGS. 5 to 6E) configured to seal a gap between the display and the second housing, slidably coupled to the base portion, and to tightly contact at least a portion of the display; and an elastic portion (e.g., the elastic portion 440 of FIGS. 5 to 6E) disposed between the base portion and the blocking portion.

According to an aspect of the disclosure, an electronic device is provided, which comprises a housing including a first housing and a second housing for guiding a slide of the first housing; a display including a first display area disposed on the first housing and a second display area extending from the first display area and configured to move at least a portion of the second display area based on the slide of the first housing; a supporting structure configured to support at least a portion of the first display area or at least a portion of the second display area and including a plurality of bars; and a blocking member disposed in the housing, wherein the blocking member includes, a base portion including at least a portion coupled to the housing; a blocking portion slidably coupled to the base portion; and an elastic portion disposed between the base portion and the blocking portion. The blocking portion may include, a first blocking portion including at least a portion slidably coupled to the base portion and configured to be pressurized from the elastic portion or at least one of the plurality of bars; and a second blocking portion coupled to the first blocking portion and configured to allow at least a portion of the second blocking portion to tightly contact the display or to be spaced apart from the display. The first blocking portion and the second blocking portion may be integrally formed with each other. The supporting structure may be configured to, when the housing is in the closed state or the opened state, be spaced apart from the blocking portion, and when the housing changes from the closed state to the opened state or when the housing changes from the opened state to the closed state, pressurize at least a portion of the blocking portion.

According to an aspect of the disclosure, an electronic device is provided which comprising: a housing including a first housing and a second housing for guiding a slide of the first housing; a display including a first display area disposed on the first housing and a second display area extending from the first display area and configured to move at least a portion of the second display area based on the slide of the first housing; a supporting structure configured to support at least a portion of the first display area or at least a portion of the second display area and including a plurality of bars; and a blocking member disposed in the housing, wherein the blocking member includes, a base portion including at least a portion disposed on a seating structure formed in the second housing; a blocking portion configured to seal a gap between the display and the second housing, slidably coupled to the base portion, and to tightly contact at least a portion of the display; and an elastic portion disposed between the base portion and the blocking portion.

While the disclosure has been shown and described with reference to exemplary embodiments thereof, it will be apparent to those of ordinary skill in the art that various changes in form and detail may be made thereto without departing from the scope of the disclosure as defined by the following claims.

## Claims

1. An electronic device comprising:
a housing including a first housing (201, 301, 501) and a second housing (202, 302, 502) for guiding a slide of the first housing (201, 301, 501);
a display (203, 303) including a first display area (A1) disposed on the first housing (201, 301, 501) and a second display area (A2) extending from the first display area (A1) and configured to move at least a portion of the second display area (A2) based on the slide of the first housing (201, 301, 501);
a supporting structure (330) configured to support at least a portion of the first display area (A1) or at least a portion of the second display area (A2) and including a plurality of bars (331); and
a blocking member (400) for blocking influx of an external foreign object through a gap between the housing and the display (203),
**characterized in that** the plurality of bars (331) include a plurality of first bars (R1, R2, R3) having a first length and a plurality of second bars (R4) having a second length larger than the first length, and
wherein when the first housing (201, 301, 501) slides with respect to the second housing (202, 302, 502), at least one of the plurality of second bars (R4) is configured to pressurize and push out the blocking member (400) to space the display (203, 303) and the blocking member (400) apart from each other.

2. The electronic device of claim 1, wherein the blocking member (400) includes,
a base portion including at least a portion coupled to the housing;
a blocking portion slidably coupled to the base portion; and
an elastic portion disposed between the base portion and the blocking portion,
and wherein the blocking portion is configured to,
when the housing is in a closed state or an opened state, be pressurized by the elastic portion to slide away from the base portion to allow at least a portion of the blocking portion to tightly contact the display (203, 303), and
when the housing changes from the closed state to the opened state or when the housing changes from the opened state to the closed state, be pressurized by from at least one of the plurality of second bars (R4) to slide toward the base portion to allow the at least a portion of the blocking portion to be spaced apart from the display (203, 303).

3. The electronic device of claim 1 or 2, wherein the blocking portion includes,
a first blocking portion including at least a portion slidably coupled to the base portion and configured to be pressurized from the elastic portion or at least one of the plurality of second bars (R4); and
a second blocking portion coupled to the first blocking portion and configured to allow at least a portion of the second blocking portion to tightly contact the display (203, 303) or to be spaced apart from the display (203, 303),
and wherein the second blocking portion,
includes at least one of a rubber material or a silicone material.

4. The electronic device of claim 3, wherein the second blocking portion is shaped to gradually reduce in cross-sectional area from a portion connected with the first blocking portion to a portion configured to tightly contact or be spaced apart from the display (203, 303).

5. The electronic device of claim 2, wherein the blocking member (400) further includes a cover portion configured so that at least a portion of the cover portion is coupled to the base portion, and another portion other than the at least the portion of the cover portion is stuck to at least a portion of the blocking portion and configured to prevent the blocking portion from escaping off the base portion when the blocking portion approaches the display (203, 303).

6. The electronic device of claim 5, wherein the blocking portion includes a fixing groove depressed in at least a portion, and
wherein the cover portion includes a fixing portion fixed to the base portion, an extension extending from the fixing portion to the blocking portion, and a bending portion bent from the extension and inserted to the fixing groove.

7. The electronic device of any of claims 1-6, wherein the second housing (202, 302, 502) includes a first sidewall including a seating structure, and
wherein the blocking member (400) is disposed on the seating structure.

8. The electronic device of claim 7, further comprising a deco member coupled to the first sidewall of the second housing (202, 302, 502) and configured to cover the blocking member (400).

9. The electronic device of claim 3, wherein at least a portion of the first blocking portion configured to tightly contact at least a portion of the second housing (202, 302, 502) and another portion of the first blocking portion, different from the at least the portion of the first blocking portion, configured to tightly contact another portion different from the at least the portion of the second housing (202, 302, 502).

10. The electronic device of claim 2, wherein when the at least the portion of the blocking portion is spaced apart from the display (203, 303), the spacing distance between the at least a portion of the blocking portion and the display (203, 303) is 0.05mm to 0.15mm.

11. The electronic device of claim 1, wherein at least one of the plurality of first bars (R1, R2, R3) is disposed to overlap a partial area of the blocking portion in the first direction when the housing is in the closed state or the opened state, and
at least one of the plurality of second bars (R4) is configured to pressurize the partial area when the housing changes from the closed state to the opened state or when the housing changes from the opened state to the closed state.

12. The electronic device of claim 11, wherein the elastic portion is configured to,
when the housing is in the closed state or the opened state, pressurize the blocking portion to slide the blocking portion to bring the at least a portion of the blocking portion in tight contact with the display (203, 303), and
be pressurized and compressed by the blocking portion when the housing changes from the closed state to the opened state or when the housing changes from the opened state to the closed state.

13. The electronic device of any of claims 11-12, wherein the plurality of second bars (R4) are continuously arranged,
wherein at least some of the plurality of first bars (R1, R2, R3) are disposed on one side of the plurality of second bars (R4), and
wherein others of the plurality of first bars (R1, R2, R3) are disposed on another side of the plurality of second bars (R4).

14. The electronic device of any of claims 11-13, wherein at least one of the plurality of first bars (R1, R2, R3) is disposed between a pair of adjacent second bars (R4) among the plurality of second bars.

## Patentansprüche

1. Elektronische Vorrichtung, umfassend:
ein Gehäuse, das ein erstes Gehäuse (201, 301, 501) und ein zweites Gehäuse (202, 302, 502) zum Führen eines Gleitens des ersten Gehäuses (201, 301, 501) beinhaltet;
eine Anzeige (203, 303), die einen ersten Anzeigebereich (A1), der auf dem ersten Gehäuse (201, 301, 501) angeordnet ist, und einen zweiten Anzeigebereich (A2) beinhaltet, der sich von dem ersten Anzeigebereich (A1) erstreckt, und konfiguriert ist, um zumindest einen Abschnitt des zweiten Anzeigebereichs (A2) basierend auf dem Gleiten des ersten Gehäuses (201, 301, 501) zu bewegen;
eine Stützstruktur (330), die so konfiguriert ist, dass sie mindestens einen Abschnitt des ersten Anzeigebereichs (A1) oder mindestens einen Abschnitt des zweiten Anzeigebereichs (A2) stützt, und eine Vielzahl von Stäben (331) beinhaltet; und
ein Blockierelement (400) zum Blockieren des Eindringens eines externen Fremdkörpers durch einen Spalt zwischen dem Gehäuse und der Anzeige (203),
**dadurch gekennzeichnet, dass**
die Vielzahl von Stäben (331) eine Vielzahl von ersten Stäben (R1, R2, R3) mit einer ersten Länge und
eine Vielzahl von zweiten Stäben (R4) mit einer zweiten Länge, die größer als die erste Länge ist, beinhaltet, und
wobei, wenn das erste Gehäuse (201, 301, 501) in Bezug auf das zweite Gehäuse (202, 302, 502) gleitet, mindestens einer der Vielzahl von zweiten Stäben (R4) konfiguriert ist, um das Blockierelement (400) unter Druck zu setzen und herauszuschieben, um die Anzeige (203, 303) und das Blockierelement (400) voneinander zu beabstanden.

2. Elektronische Vorrichtung nach Anspruch 1, wobei das Blockierelement (400) Folgendes beinhaltet:
einen Basisabschnitt, der mindestens einen mit dem Gehäuse gekoppelten Abschnitt beinhaltet;
einen Blockierabschnitt, der gleitend mit dem Basisabschnitt gekoppelt ist; und
einen elastischen Abschnitt, der zwischen dem Basisabschnitt und dem Blockierabschnitt angeordnet ist, und wobei der Blockierabschnitt konfiguriert ist, um:
wenn sich das Gehäuse in einem geschlossenen Zustand oder in einem geöffneten Zustand befindet, durch den elastischen Abschnitt unter Druck gesetzt zu werden, um weg von dem Basisabschnitt zu gleiten, um zu ermöglichen, dass mindestens ein Abschnitt des Blockierabschnitts die Anzeige (203, 303) fest berührt, und
wenn das Gehäuse aus dem geschlossenen Zustand in den geöffneten Zustand übergeht oder wenn das Gehäuse aus dem geöffneten Zustand in den geschlossenen Zustand übergeht, durch mindestens einen der Vielzahl von zweiten Stäben (R4) unter Druck gesetzt zu werden, um in Richtung des Basisabschnitts zu gleiten, um zu ermöglichen, dass der mindestens eine Abschnitt des Blockierabschnitts von der Anzeige (203, 303) beabstandet wird.

3. Elektronische Vorrichtung nach Anspruch 1 oder 2, wobei der Blockierabschnitt Folgendes beinhaltet:
einen ersten Blockierabschnitt, der mindestens einen Abschnitt beinhaltet, der gleitend mit dem Basisabschnitt gekoppelt und so konfiguriert ist, dass er von dem elastischen Abschnitt oder mindestens einem der Vielzahl von zweiten Stäben (R4) unter Druck gesetzt wird; und
einen zweiten Blockierabschnitt, der mit dem ersten Blockierabschnitt gekoppelt und so konfiguriert ist, dass ermöglicht wird, dass mindestens ein Abschnitt des zweiten Blockierabschnitts die Anzeige (203, 303) fest berührt oder von der Anzeige (203, 303) beabstandet ist,
und wobei der zweite Blockierabschnitt
mindestens eines von einem Gummimaterial oder einem Silikonmaterial beinhaltet.

4. Elektronische Vorrichtung nach Anspruch 3, wobei der zweite Blockierabschnitt so geformt ist, dass sich eine Querschnittsfläche von einem Abschnitt, der mit dem ersten Blockierabschnitt verbunden ist, zu einem Abschnitt, der so konfiguriert ist, dass er die Anzeige (203, 303) fest berührt oder von ihr beabstandet ist, graduell verringert.

5. Elektronische Vorrichtung nach Anspruch 2, wobei das Blockierelement (400) ferner einen Abdeckabschnitt beinhaltet, der so konfiguriert ist, dass mindestens ein Abschnitt des Abdeckabschnitts mit dem Basisabschnitt gekoppelt ist und ein anderer Abschnitt als der mindestens eine Abschnitt des Abdeckabschnitts an mindestens einem Abschnitt des Blockierabschnitts haftet und so konfiguriert ist, dass verhindert wird, dass sich der Blockierabschnitt von dem Basisabschnitt löst, wenn sich der Blockierabschnitt der Anzeige (203, 303) nähert.

6. Elektronische Vorrichtung nach Anspruch 5, wobei der Blockierabschnitt eine Befestigungsnut beinhaltet, die in mindestens einem Abschnitt vertieft ist, und
wobei der Abdeckabschnitt einen an dem Basisabschnitt befestigten Befestigungsabschnitt, eine Verlängerung, die sich von dem Befestigungsabschnitt zu dem Blockierabschnitt erstreckt, und einen Biegeabschnitt beinhaltet, der von der Verlängerung gebogen und in die Befestigungsnut eingesetzt ist.

7. Elektronische Vorrichtung nach einem der Ansprüche 1-6, wobei das zweite Gehäuse (202, 302, 502) eine erste Seitenwand beinhaltet, die eine Aufnahmestruktur beinhaltet, und
wobei das Blockierelement (400) an der Aufnahmestruktur angeordnet ist.

8. Elektronische Vorrichtung nach Anspruch 7, ferner umfassend ein Dekoelement, das mit der ersten Seitenwand des zweiten Gehäuses (202, 302, 502) gekoppelt und so konfiguriert ist, dass es das Blockierelement (400) abdeckt.

9. Elektronische Vorrichtung nach Anspruch 3, wobei mindestens ein Abschnitt des ersten Blockierabschnitts so konfiguriert ist, dass er mindestens einen Abschnitt des zweiten Gehäuses (202, 302, 502) fest berührt, und ein anderer Abschnitt des ersten Blockierabschnitts, der sich von dem mindestens einen Abschnitt des ersten Blockierabschnitts unterscheidet, so konfiguriert ist, dass er einen anderen Abschnitt fest berührt, der sich von dem mindestens einen Abschnitt des zweiten Gehäuses (202, 302, 502) unterscheidet.

10. Elektronische Vorrichtung nach Anspruch 2, wobei, wenn der mindestens eine Abschnitt des Blockierabschnitts von der Anzeige (203, 303) beabstandet ist, die Beabstandung zwischen dem mindestens einen Abschnitt des Blockierabschnitts und der Anzeige (203, 303) 0,05 mm bis 0,15 mm beträgt.

11. Elektronische Vorrichtung nach Anspruch 1, bei der mindestens einer der Vielzahl von ersten Stäben (R1, R2, R3) so angeordnet ist, dass er einen Teilbereich des Blockierabschnitts in der ersten Richtung überlappt, wenn sich das Gehäuse im geschlossenen Zustand oder im geöffneten Zustand befindet, und mindestens einer der Vielzahl von zweiten Stäben (R4) konfiguriert ist, um den Teilbereich unter Druck zu setzen, wenn das Gehäuse aus dem geschlossenen Zustand in den geöffneten Zustand übergeht oder wenn das Gehäuse aus dem geöffneten Zustand in den geschlossenen Zustand übergeht.

12. Elektronische Vorrichtung nach Anspruch 11, wobei der elastische Abschnitt konfiguriert ist, um:
wenn sich das Gehäuse im geschlossenen Zustand oder im geöffneten Zustand befindet, den Blockierabschnitt unter Druck zu setzen, um den Blockierabschnitt gleiten zu lassen, um den mindestens einen Abschnitt des Blockierabschnitts in festen Kontakt mit der Anzeige (203, 303) zu bringen, und
durch den Blockierabschnitt unter Druck gesetzt und komprimiert zu werden, wenn das Gehäuse aus dem geschlossenen Zustand in den geöffneten Zustand übergeht oder wenn das Gehäuse aus dem geöffneten Zustand in den geschlossenen Zustand übergeht.

13. Elektronische Vorrichtung nach einem der Ansprüche 11-12, wobei die Vielzahl von zweiten Stäben (R4) kontinuierlich angeordnet ist,
wobei zumindest einige der Vielzahl von ersten Stäben (R1, R2, R3) auf einer Seite der Vielzahl von zweiten Stäben (R4) angeordnet sind, und
wobei andere aus der Vielzahl von ersten Stäben (R1, R2, R3) auf einer anderen Seite der Vielzahl von zweiten Stäben (R4) angeordnet sind.

14. Elektronische Vorrichtung nach einem der Ansprüche 11-13, wobei mindestens einer der Vielzahl von ersten Stäben (R1, R2, R3) zwischen einem Paar von benachbarten zweiten Stäben (R4) aus der Vielzahl von zweiten Stäben angeordnet ist.

## Revendications

1. Dispositif électronique, comprenant :
un boîtier comprenant un premier boîtier (201, 301, 501) et un deuxième boîtier (202, 302, 502) destiné à guider un glissement du premier boîtier (201, 301, 501) ;
un affichage (203, 303) comprenant une première zone d'affichage (A1) disposée sur le premier boîtier (201, 301, 501) et une deuxième zone d'affichage (A2) s'étendant à partir de la première zone d'affichage (A1) et configurée pour déplacer au moins une partie de la deuxième zone d'affichage (A2) basée sur le glissement du premier boîtier (201, 301, 501) ;
une structure de support (330) configurée pour supporter au moins une partie de la première zone d'affichage (A1) ou au moins une partie de la deuxième zone d'affichage (A2) et comprenant une pluralité de barres (331) ; et
un élément de blocage (400) pour bloquer l'afflux d'un corps étranger externe à travers un espace entre le boîtier et l'affichage (203),
**caractérisé en ce que**
la pluralité de barres (331) comprend une pluralité de premières barres (R1, R2, R3) ayant une première longueur et une pluralité de deuxièmes barres (R4) ayant une deuxième longueur plus grande que la première longueur, et
dans lequel, lorsque le premier boîtier (201, 301, 501) coulisse par rapport au deuxième boîtier (202, 302, 502), au moins une de la pluralité de deuxièmes barres (R4) est configurée pour faire pression et repousser l'élément de blocage (400) afin d'espacer l'affichage (203, 303) et l'élément de blocage (400) l'un par rapport à l'autre.

2. Dispositif électronique de la revendication 1, dans lequel l'élément de blocage (400) comprend,
une partie de base comprenant au moins une partie couplée au boîtier ;
une partie de blocage couplée de manière coulissante à la partie de base ; et
une partie élastique disposée entre la partie de base et la partie de blocage,
et dans lequel la partie de blocage est configuré pour
lorsque le boîtier est dans un état fermé ou un état ouvert, être mise sous pression par la partie élastique pour glisser loin de la partie de base afin de permettre à au moins une partie de la partie de blocage d'être en contact étroit avec l'affichage (203, 303), et
lorsque le boîtier passe de l'état fermé à l'état ouvert ou lorsque le boîtier passe de l'état ouvert à l'état fermé, être mise sous pression à partir d'au moins une de la pluralité de deuxièmes barres (R4) pour glisser vers la partie de base afin de permettre à l'au moins une partie de la partie de blocage d'être espacée de l'affichage (203, 303).

3. Dispositif électronique de la revendication 1 ou 2, dans lequel la partie de blocage comprend,
une première partie de blocage comprenant au moins une partie couplée de manière coulissante à la partie de base et configurée pour être mise sous pression à partir de la partie élastique ou d'au moins une de la pluralité de deuxièmes barres (R4) ; et
une deuxième partie de blocage couplée à la première partie de blocage et configurée pour permettre à au moins une partie de la deuxième partie de blocage d'entrer en contact étroit avec l'affichage (203, 303) ou d'être espacée de l'affichage (203, 303),
et dans lequel la deuxième partie de blocage
comprend au moins un d'un matériau de caoutchouc ou d'un matériau de silicone.

4. Dispositif électronique de la revendication 3, dans lequel la deuxième partie de blocage est façonnée pour réduire progressivement la zone de section transversale à partir d'une partie reliée à la première partie de blocage jusqu'à une partie configurée pour entrer en contact étroit avec ou être espacée de l'affichage (203, 303).

5. Dispositif électronique de la revendication 2, dans lequel l'élément de blocage (400) comprend en outre une partie de couvercle configurée de sorte qu'au moins une partie de la partie de couvercle est couplée à la partie de base, et une autre partie autre que l'au moins la partie de la partie de couvercle est collée à au moins une partie de la partie de blocage et configurée pour empêcher la partie de blocage de s'échapper de la partie de base lorsque l'élément de blocage s'approche de l'affichage (203, 303).

6. Dispositif électronique de la revendication 5, dans lequel la partie de blocage comprend une rainure de fixation enfoncée dans au moins une partie, et
dans lequel la partie de couvercle comprend une partie de fixation fixée à la partie de base, une extension s'étendant de la partie de fixation à la partie de blocage, et une partie de courbure courbée à partir de l'extension et insérée dans la rainure de fixation.

7. Dispositif électronique de l'une des revendications 1 à 6, dans lequel le deuxième boîtier (202, 302, 502) comprend une première paroi latérale comprenant une structure d'assise, et
dans lequel l'élément de blocage (400) est disposé sur la structure d'assise.

8. Dispositif électronique de la revendication 7, comprenant en outre un élément de décoration couplé à la première paroi latérale du deuxième boîtier (202, 302, 502) et configuré pour couvrir l'élément de blocage (400).

9. Dispositif électronique selon la revendication 3, dans lequel au moins une partie de la première partie de blocage configurée pour entrer en contact étroit avec l'au moins une partie du deuxième boîtier (202, 302, 502) et une autre partie de la première partie de blocage, différente de l'au moins partie de la première partie de blocage, configurée pour entrer en contact étroit avec une autre partie différente de l'au moins la partie du deuxième boîtier (202, 302, 502).

10. Dispositif électronique de la revendication 2, dans lequel lorsque l'au moins la partie de la partie de blocage est espacée de l'affichage (203, 303), la distance d'espacement entre l'au moins une partie de la partie de blocage et l'affichage (203, 303) est de 0,05 mm à 0,15 mm.

11. Dispositif électronique de la revendication 1, dans lequel au moins une de la pluralité de premières barres (R1, R2, R3) est disposée pour chevaucher une zone partielle de la partie de blocage dans la première direction lorsque le boîtier est à l'état fermé ou à l'état ouvert, et.
au moins une de la pluralité de deuxièmes barres (R4) est configurée pour mettre sous pression la zone partielle lorsque le boîtier passe de l'état fermé à l'état ouvert ou lorsque le boîtier passe de l'état ouvert à l'état fermé.

12. Dispositif électronique selon la revendication 11, dans lequel la partie élastique est configurée pour, lorsque le boîtier est à l'état fermé ou à l'état ouvert, mettre sous pression la partie de blocage pour faire glisser la partie de blocage afin d'amener l'au moins une partie de la partie de blocage en contact étroit avec l'affichage (203, 303), et
être mise sous pression et comprimée par la partie de blocage lorsque le boîtier passe de l'état fermé à l'état ouvert ou lorsque le boîtier passe de l'état ouvert à l'état fermé.

13. Dispositif électronique de l'une quelconque des revendications 11 à 12, dans lequel la pluralité de deuxièmes barres (R4) sont disposées en continu,
dans lequel au moins quelques-unes de la pluralité de premières barres (R1, R2, R3) sont disposées sur un côté de la pluralité de deuxièmes barres (R4), et
dans lequel d'autres barres de la pluralité de premières barres (R1, R2, R3) sont disposées sur un autre côté de la pluralité de deuxièmes barres (R4).

14. Dispositif électronique de l'une quelconque des revendications 11 à 13, dans lequel au moins une de la pluralité de premières barres (R1, R2, R3) est disposée entre une paire de deuxièmes barres adjacentes (R4) parmi la pluralité de deuxièmes barres.
